# EUROPÄISCHE PATENTANMELDUNG

(11) **EP 2 600 609 A2**
(43) Veröffentlichungstag der Anmeldung: **05.06.2013**
(21) Anmeldenummer: 12194668.5
(22) Anmeldetag: 28.11.2012
(51) Int. Cl.: H04N 5/378

(54) **Bildsensor und Verfahren zum Auslesen eines Bildsensors**

(30) Priorität: 02.12.2011 DE 102011120099
(71) Anmelder: Arnold & Richter Cine Technik GmbH & Co. Betriebs KG, 80799 München (DE)
(72) Erfinder: Cieslinski, Michael, 85521 Ottobrunn (DE)
(74) Vertreter: Manitz, Finsterwald & Partner GbR

(57) **Zusammenfassung**

Ein Bildsensor, insbesondere CMOS-Bildsensor, für elektronische Kameras umfasst eine Vielzahl von in Zeilen und Spalten angeordneten lichtempfindlichen Pixeln zur Erzeugung von belichtungsabhängigen Pixelsignalen. Einer jeweiligen Spalte sind mehrere Spaltenleitungen, wenigstens eine Vorladeschaltung zum Laden oder Entladen der Spaltenleitungen und wenigstens eine Spaltenausleseschaltung zum Auslesen der Pixelsignale der jeweiligen Spalte zugeordnet. Der Bildsensor weist zumindest eine Umschalteinrichtung auf, welche angepasst ist, in einem ersten Schaltzustand eine der Spaltenleitungen einer jeweiligen Spalte mit der Vorladeschaltung und eine andere der Spaltenleitungen der jeweiligen Spalte mit der Spaltenausleseschaltung zu koppeln.

## Beschreibung

Die vorliegende Erfindung betrifft einen Bildsensor, insbesondere CMOS-Bildsensor, für elektronische Kameras, mit einer Vielzahl von in Zeilen und Spalten angeordneten lichtempfindlichen Pixeln zur Erzeugung von belichtungsabhängigen Pixelsignalen, wobei einer jeweiligen Spalte mehrere Spaltenleitungen, wenigstens eine Vorladeschaltung zum Laden oder Entladen der Spaltenleitungen und wenigstens eine Spaltenausleseschaltung zum Auslesen der Pixelsignale der jeweiligen Spalte zugeordnet sind. Die Erfindung betrifft ferner ein entsprechendes Verfahren zum Auslesen eines Bildsensors.

Eine elektronische Kamera wird beispielsweise dazu verwendet, um Bildsequenzen digital aufzuzeichnen, die später in einem Kino vorgeführt werden. Dabei ist es vorteilhaft, wenn diese Kamera neben einer hohen Lichtempfindlichkeit und Dynamik auch eine hohe Bildrate, d.h. eine hohe Bildwiederholfrequenz aufweist. Dies ist insbesondere für Aufnahmen wichtig, die später in Zeitlupe wiedergegeben werden sollen. Eine weitere Anwendung, bei der sehr hohe Bildraten notwendig sind, ist beispielsweise die Aufnahme von Automobil-Crash-Tests.

Der Bildsensor einer derartigen Kamera wandelt dabei durch das Objektiv der Kamera fallendes Licht in elektrische Signale um und umfasst eine Vielzahl von lichtempfindlichen Elementen, die sogenannten Pixel, die üblicherweise in Zeilen und Spalten angeordnet sind und das Bildfeld bilden. Typischerweise werden auf Siliziumbasis in CMOS- oder CCD-Technologie hergestellte Bildsensoren verwendet.

Zum Auslesen eines von der Kamera aufgenommenen Bildes werden die Pixel beispielsweise zeilenweise adressiert, und eine zu der Ladung des jeweiligen Pixels proportionale Spannung wird erzeugt, die zu einem Ausgang des Bildsensors geleitet wird. Die in einer jeweiligen Spalte angeordneten Pixel sind wenigstens einer gemeinsamen Spaltenleitung zugeordnet und mit dieser wahlweise verbindbar. Die Spaltenleitungen (auch "bitlines" genannt) bilden den sogenannten Spaltenbus und leiten die Signale der Pixel zu Spaltenausleseschaltungen, die am Rand des Bildfelds angeordnet sind und die beispielsweise Spaltenverstärkerschaltungen und/oder Signalverarbeitungsschaltungen umfassen.

Eine Vorladeschaltung dient einem (auch als "Pre-Charge" bezeichneten) Laden oder Entladen der Spaltenleitungen auf einen vorbestimmten Wert, insbesondere bevor über die jeweilige Spaltenleitung ein belichtungsabhängiges Pixelsignal (insbesondere ein Spannungswert) ausgegeben wird. Beispielsweise werden die Spaltenleitungen hierzu zeitweise, insbesondere unmittelbar vor dem Auslesen eines jeweiligen Pixel, und/oder kontinuierlich mit einem Referenzpotential, beispielsweise einem Massepotential, verbunden.

Bei einem derartigen Bildsensor wird die Bildrate im Wesentlichen durch zwei Faktoren begrenzt, nämlich durch die Durchsatzrate des Spaltenbusses und durch die Durchsatzrate der am Rand des Bildfelds vorgesehenen Spaltenausleseschaltungen. Auch die Dauer von Ladungstransfers innerhalb der Pixel können die Auslesegeschwindigkeit und somit die Bildrate nachteilig beeinflussen. Der Durchsatz bei der Signalverarbeitung kann gesteigert werden, indem mehrere parallel arbeitende Signalverarbeitungsschaltungen jeweiligen Gruppen von Spaltenleitungen zugeordnet werden. Schwieriger ist es jedoch, die Durchsatzrate des Spaltenbusses zu steigern. Beispielsweise gibt es die Möglichkeit, die Spaltenleitungen in der Mitte zu teilen und den oberen Teil des Bildfeldes über am oberen Bildrand vorgesehene Spaltenausleseschaltungen auszulesen, während der untere Teil des Bildfelds über am unteren Bildrand vorgesehene Spaltenausleseschaltungen ausgelesen wird.

Weiterhin ist es möglich, einer Spalte zwei oder sogar vier parallele, mit einer jeweiligen Spaltenausleseschaltung verbundene Spaltenleitungen zuzuordnen, mit denen dann die Pixelsignale von zwei oder vier verschiedenen Zeilen simultan ausgelesen werden können. Allerdings verdecken diese Leitungen einen Teil der lichtempfindlichen Fläche des Pixels und reduzieren so die Lichtempfindlichkeit. Somit sind einer weiteren Erhöhung der Anzahl der parallelen Spaltenleitungen Grenzen gesetzt.

Ein weiterer Nachteil besteht in dem hohen Platzbedarf für die Spaltenausleseschaltungen. Zum Beispiel benötigt jede Spaltenausleseschaltung bei einem Bildsensor mit einer Pixelgröße von 5 µm x 5 µm eine Fläche von etwa 5 µm x 800 µm. Bei einem Bildsensor, welcher je Spalte vier parallele Spaltenleitungen aufweist, müssen für jede Spalte vier Spaltenausleseschaltungen vorgesehen werden, die aus Platzgründen oberhalb und/oder unterhalb des Bildfeldes in Verlängerung der Spaltenleitungen in Reihe angeordnet werden können. Somit beträgt der über das eigentliche Bildfeld hinausgehende Platzbedarf bei einem Bildsensor mit mittig geteilten Spaltenleitungen und am oberen und am unteren Bildrand vorgesehenen Signalverarbeitungsschaltungen auf jeder Seite des Bildfeldes 3,2 mm, also insgesamt 6,4 mm. Die damit verbundene Vergrößerung der Chipfläche erhöht die Herstellungskosten des Sensors. Zudem wird durch die große Fläche die Ausbeute bei der Chipproduktion reduziert, da bei einer angenommenen konstanten Defektdichte ein Defekt mit zunehmender Chipfläche immer wahrscheinlicher wird.

Als weiteres Problem tritt bei der Verwendung mehrerer paralleler Spaltenleitungen ein Übersprechen zwischen einzelnen parallelen, insbesondere benachbarten Spaltenleitungen auf. Da nämlich die Spaltenleitungen über eine relativ lange Distanz unmittelbar nebeneinander verlaufen, weisen sie eine hohe kapazitive Kopplung auf. Das aufgrund dieser kapazitiven Kopplung auftretende Übersprechen führt zu Artefakten im Bild.

Die Kopplung kann vermieden werden, wenn zwischen den Spaltenleitungen zusätzliche Leitungen zur Abschirmung verlegt werden, welche bevorzugt mit einem definierten Potential des Sensors verbunden sind. Während bei einem Sensor mit zwei parallelen Spaltenleitungen pro Spalte eine Abschirmung noch möglich ist, führt bei Sensoren mit vier oder mehr Spaltenleitungen pro Spalte die mit der Anordnung zusätzlicher Abschirmleitungen einhergehende Abschattung zu einer nicht mehr hinnehmbaren Reduktion der lichtempfindlichen Fläche der Pixel und damit zu einer Reduktion der Lichtempfindlichkeit.

Es ist daher die Aufgabe der Erfindung, einen Bildsensor und ein Verfahren der erläuterten Art zu schaffen, welche ohne substantielle Einbuße bei der Lichtempfindlichkeit die Aufnahme von Bildern mit hoher Bildrate ermöglichen.

Diese Aufgabe wird durch einen Bildsensor mit den Merkmalen des Anspruchs 1 gelöst, und insbesondere dadurch, dass der jeweiligen Spalte wenigstens eine Umschalteinrichtung zugeordnet ist, welche angepasst ist, in einem ersten Schaltzustand eine der Spaltenleitungen der jeweiligen Spalte mit der Vorladeschaltung und eine andere der Spaltenleitungen der jeweiligen Spalte mit der Spaltenausleseschaltung zu koppeln.

Da auf der einen Spaltenleitung also lediglich ein Vorladevorgang stattfindet, während auf der anderen Spaltenleitung ein Auslesevorgang erfolgt, ist ein auf kapazitiver Kopplung beruhendes Übersprechen zwischen den unmittelbar oder indirekt benachbarten Spaltenleitungen und damit die Entstehung entsprechender Artefakte weitgehend ausgeschlossen. Somit ist es möglich, die Spaltenleitungen relativ nah zueinander und insbesondere ohne dazwischen liegende zusätzliche Abschirmleitung auf dem Bildsensor anzuordnen. Die Vorladeschaltung kann beispielsweise eine Stromquelle oder eine Referenzpotentialquelle umfassen.

Grundsätzlich kann die Umschalteinrichtung auf verschiedene Arten ausgestaltet sein. Im einfachsten Fall kann diese einen Kreuzschalter umfassen, welcher beim Wechsel des Schaltzustands die jeweilige Verbindung der einen und der anderen Spaltenleitung einerseits mit der Spaltenausleseschaltung und der Vorladeschaltung andererseits vertauscht. Prinzipiell kann die Umschalteinrichtung aber auch beispielsweise zwei Wechselschalter oder vier Einzelschalter umfassen, die auf geeignete Weise angesteuert werden, um die jeweiligen Schaltzustände herzustellen. Die Ansteuerung der Umschalteinrichtung kann beispielsweise dadurch erfolgen, dass der Bildsensor eine Steuereinrichtung aufweist, welche zum Steuern der Umschalteinrichtung angepasst ist, insbesondere über eine gemeinsame Steuerleitung für mehrere Schalter der Umschalteinrichtung.

Gemäß einer bevorzugten Ausführungsform ist die Umschalteinrichtung dazu angepasst, in einem zweiten Schaltzustand die genannte eine der Spaltenleitungen mit der Spaltenausleseschaltung oder einer weiteren Spaltenausleseschaltung der jeweiligen Spalte (oder einer anderen Spalte) und die genannte andere der Spaltenleitungen mit der Vorladeschaltung oder einer weiteren Vorladeschaltung der jeweiligen Spalte (oder einer anderen Spalte) zu koppeln. Insbesondere kann die Umschalteinrichtung zwischen den beiden Schaltzuständen alternieren. Somit ist es insbesondere möglich, die Anzahl der benötigten Spaltenausleseschaltungen zu verringern. Während bei herkömmlichen Bildsensoren das Laden oder Entladen der Spaltenleitungen mittels der Vorladeschaltung und das Auslesen der mit den Spaltenleitungen verbundenen Pixel abwechselnd und für alle Spaltenleitungen gleichzeitig erfolgt, ist es durch die vorstehend beschriebene wechselweise Verbindung der Spaltenleitungen mit der Spaltenausleseschaltung und der Vorladeschaltung mittels der Umschalteinrichtung möglich, über einen Teil der Spaltenleitungen der jeweiligen Spalte die Pixelsignale auszulesen, während zur selben Zeit ein anderer Teil der Spaltenleitungen geladen oder entladen wird. Insbesondere kann die genannte Steuereinrichtung dazu angepasst sein, die Umschalteinrichtung derart zu steuern, dass die Umschalteinrichtung für das Auslesen verschiedener Pixelsignale der jeweiligen Spalte zwischen dem ersten Schaltzustand und dem zweiten Schaltzustand alterniert, d.h. ein Umschalten erfolgt für verschiedene Pixel innerhalb der jeweiligen Spalte.

Somit werden gegenüber einem vergleichbaren herkömmlichen Bildsensor, bei dem jeder Spaltenleitung eine eigene Spaltenausleseschaltung zugeordnet ist, nur halb so viele Spaltenausleseschaltungen benötigt. Dadurch reduziert sich der Flächenbedarf für den Bildsensor-Chip. Umgekehrt bedeutet dies bei gegebener Fläche, die für die Spaltenausleseschaltungen zur Verfügung steht, dass eine höhere Durchsatzrate der vorhandenen Spaltenausleseschaltungen und somit eine höhere Bildrate erreicht werden können. Zudem verringert sich die Gefahr eines Übersprechens zwischen benachbarten Spaltenleitungen, insbesondere bei Spalten mit zwei Spaltenleitungen, aber auch - wie nachfolgend noch erläutert wird - bei Spalten mit mehr als zwei Spaltenleitungen, wenn die Spaltenleitungen auf geeignete Weise angeordnet werden.

Gemäß einer vorteilhaften Ausführungsform sind einer jeweiligen Spalte vier Spaltenleitungen zugeordnet, nämlich zwei erste Spaltenleitungen und zwei zweite Spaltenleitungen. Ein jeweiliger Teil der Pixel dieser Spalte ist mit einer der vier Spaltenleitungen verbunden oder (über einen Zeilenauswahlschalter) verbindbar. In dem genannten ersten Schaltzustand der Umschalteinrichtung sind die zwei ersten Spaltenleitungen mit der wenigstens einen Vorladeschaltung und die zwei zweiten Spaltenleitungen mit der wenigstens einen Spaltenausleseschaltung gekoppelt, und in dem genannten zweiten Schaltzustand der Umschalteinrichtung sind die zwei ersten Spaltenleitungen mit der wenigstens einen Spaltenausleseschaltung und die zwei zweiten Spaltenleitungen mit der wenigstens einen Vorladeschaltung gekoppelt. Somit erfolgt bei dieser Ausführungsform ein paarweises Umschalten zwischen dem Vorladen der Spaltenleitungen und dem Auslesen der Pixelsignale.

Bei dieser Ausführungsform mit vier Spaltenleitungen ist es bevorzugt, wenn der jeweiligen Spalte zumindest eine erste Vorladeschaltung und eine zweite Vorladeschaltung, eine erste Spaltenausleseschaltung und eine zweite Spaltenausleseschaltung, sowie eine erste Umschalteinrichtung und eine zweite Umschalteinrichtung zugeordnet sind, wobei die erste Vorladeschaltung, die erste Spaltenausleseschaltung und die erste Umschalteinrichtung an einem ersten Ende der jeweiligen Spalte angeordnet sind, und wobei die zweite Vorladeschaltung, die zweite Spaltenausleseschaltung und die zweite Umschalteinrichtung an einem dem ersten Ende gegenüber liegenden zweiten Ende der jeweiligen Spalte angeordnet sind. Somit sind die Vorladeschaltungen, die Spaltenausleseschaltungen und die Umschalteinrichtungen auf beiden Seiten des Bildfelds vorgesehen, so dass die zur Verfügung stehende Fläche des Bildsensors optimal genutzt werden kann.

Um die erste Spaltenausleseschaltung und die zweite Spaltenausleseschaltung zur Erzielung einer hohen Bildrate zu nutzen, kann vorgesehen sein, dass in dem ersten Schaltzustand der ersten Umschalteinrichtung und der zweiten Umschalteinrichtung der jeweiligen Spalte beispielsweise die eine der zwei zweiten Spaltenleitungen mit der ersten Spaltenausleseschaltung und die andere der zwei zweiten Spaltenleitungen mit der zweiten Spaltenausleseschaltung gekoppelt sind, während in dem zweiten Schaltzustand der ersten Umschalteinrichtung und der zweiten Umschalteinrichtung der jeweiligen Spalte die eine der zwei ersten Spaltenleitungen mit der ersten Spaltenausleseschaltung und die andere der zwei ersten Spaltenleitungen mit der zweiten Spaltenausleseschaltung gekoppelt sind (oder natürlich umgekehrt).

Vorzugsweise weist die Vorladeschaltung einen Trennschalter auf, um die mit der Vorladeschaltung verbundene Spaltenleitung unabhängig von der Umschalteinrichtung von einer Stromquelle der Vorladeschaltung trennen zu können. Dadurch ist es möglich, den Ladevorgang oder Entladevorgang der einen Spaltenleitung unabhängig von dem Zeitintervall zu steuern, in dem die andere Spaltenleitung der jeweiligen Spalte zum Auslesen eines Pixelsignals mit der Spaltenausleseschaltung verbunden ist.

Um nach einem Ladevorgang oder Entladevorgang die betreffende Spaltenleitung auf einem Referenzpotential halten zu können, kann die genannte Vorladeschaltung oder eine weitere Vorladeschaltung eine Referenzpotentialquelle und einen weiteren Trennschalter aufweisen, der zwischen der Umschalteinrichtung und der Referenzpotentialquelle angeordnet ist. Die Referenzpotentialquelle ist vorzugsweise parallel zu der genannten Stromquelle und dem zugeordneten Trennschalter angeordnet.

Bevorzugt sind das Schaltzeitintervall, während dessen eine jeweilige Spaltenleitung mit der Spaltenausleseschaltung gekoppelt ist, und das Schaltzeitintervall, während dessen die jeweilige Spaltenleitung mit der Vorladeschaltung gekoppelt ist, gleich lang. Obwohl die Zeitdauer, die zum Auslesen des Pixelsignals eines auf die Spaltenleitung aufgeschalteten Pixels benötigt wird, in der Regel länger ist als die Zeitdauer, die für ein Entladen oder Laden der Spaltenleitung benötigt wird, ermöglichen es gleich lange Schaltzeiten, die Umschalteinrichtung und deren Steuerung besonders einfach auszugestalten. Die daraus resultierende Verlängerung der Schaltzeit, während derer die Vorladeschaltung mit der Spaltenleitung gekoppelt ist, kann dabei hingenommen werden, da eine Umschaltung zum nächsten Schaltzustand ohnehin erst dann erfolgen kann, wenn der Auslesevorgang beendet ist.

Gemäß einer vorteilhaften Ausführungsform, beispielsweise wenn der jeweiligen Spalte zwei Spaltenleitungen zugeordnet sind, verlaufen die genannte eine der Spaltenleitungen der jeweiligen Spalte und die genannte andere der Spaltenleitungen der jeweiligen Spalte unmittelbar nebeneinander, ohne dass zwischen den beiden Spaltenleitungen eine Abschirmleitung verläuft. Dies ist möglich, da zum Beispiel in dem ersten Schaltzustand die eine Spaltenleitung mit der Vorladeschaltung gekoppelt ist und somit das Signal auf der anderen Spaltenleitung nicht stört. Dadurch vermindert sich der Platzverbrauch in Zeilenrichtung und es steht im Vergleich zu einem Bildsensor mit vorhandener Abschirmleitung zwischen benachbarten Spaltenleitungen eine größere lichtempfindliche Fläche zur Verfügung.

Gemäß einer weiteren vorteilhaften Ausführungsform, beispielsweise wenn der jeweiligen Spalte vier Spaltenleitungen zugeordnet sind, verlaufen einige oder alle der Spaltenleitungen der jeweiligen Spalte nebeneinander, beispielsweise innerhalb einer Ebene oder aber auch in mehreren Ebenen. Zwischen zwei Spaltenleitungen, die in einem bestimmten Schaltzustand der Umschalteinrichtung (z.B. erster oder zweiter Schaltzustand) mit der Spaltenausleseschaltung gekoppelt sind, verläuft bei dieser Ausführungsform eine Spaltenleitung, die in diesem Schaltzustand mit der Vorladeschaltung gekoppelt ist. Die Spaltenleitungen werden demnach so angeordnet, dass immer abwechselnd eine Spaltenleitung mit der Spaltenausleseschaltung und die unmittelbar benachbarte Spaltenleitung mit der Vorladeschaltung gekoppelt ist. Dadurch verringert sich die kapazitive Kopplung zwischen den Spaltenleitungen, die in einem bestimmten Schaltzustand mit der Spaltenausleseschaltung gekoppelt sind, und damit auch das Übersprechen zwischen diesen Spaltenleitungen.

Gemäß noch einer weiteren vorteilhaften Ausführungsform sind der jeweiligen Spalte wenigstens vier Spaltenleitungen zugeordnet, die in Querrichtung betrachtet (d.h. entlang einer Normalebene zu der Erstreckungsrichtung der Spaltenleitungen) paarweise nebeneinander und übereinander verlaufen (d.h. in einer 2 x 2 Matrix). Bei dieser Ausführungsform sind diejenigen Spaltenleitungen, die in einem bestimmten Schaltzustand der Umschalteinrichtung (z.B. erster oder zweiter Schaltzustand) mit der Spaltenausleseschaltung gekoppelt sind, diagonal benachbart zueinander angeordnet, und diejenigen Spaltenleitungen, die in diesem Schaltzustand mit der Vorladeschaltung gekoppelt sind, sind komplementär hierzu ebenfalls diagonal benachbart zueinander angeordnet. Eine derartige Anordnung von vier Spaltenleitungen minimiert einerseits den Verlust von lichtempfindlicher Bildsensorfläche und zugleich auch das Übersprechen zwischen denjenigen Spaltenleitungen, die gleichzeitig mit einer Spaltenausleseschaltung gekoppelt sind. Optional kann jedoch zusätzlich eine jeweilige Abschirmleitung zwischen zwei vertikalen und/oder horizontalen Spaltenleitungspaaren vorgesehen sein. Ferner kann das erläuterte Anordnungsprinzip auch für mehr als vier Spaltenleitungen einer jeweiligen Spalte verwirklicht werden (z.B. in einer 3 x 2 Matrix oder 4 x 2 Matrix).

Gemäß einer weiteren vorteilhaften Ausführungsform umfasst der Bildsensor eine Steuereinrichtung (insbesondere die bereits genannte Steuereinrichtung), welche den Bildsensor (insbesondere die Ladungstransferschalter innerhalb der Pixel, die Zeilenauswahlschalter und die Spaltenausleseschaltungen) folgendermaßen steuert: Für einen einzigen Belichtungsvorgang des Bildsensors werden in einem ersten der Pixel der jeweiligen Spalte mehrere Ausleseschritte durchgeführt, um mehrere Pixelsignale des ersten Pixels nacheinander zu erzeugen und an eine der Spaltenleitungen der jeweiligen Spalte auszugeben (z.B. Referenzwert und Signalwert, oder erster Signalwert und zweiter Signalwert). Für denselben Belichtungsvorgang werden auch in einem zweiten der Pixel der jeweiligen Spalte mehrere Ausleseschritte durchgeführt, um mehrere Pixelsignale des zweiten Pixels nacheinander zu erzeugen und an dieselbe Spaltenleitungen auszugeben. Zwischen den Ausleseschritten des ersten Pixels wird wenigstens ein Ausleseschritt des zweiten Pixels durchgeführt. Mit anderen Worten erfolgen für einen einzigen Belichtungsvorgang die mehreren Ausleseschritte in einem Pixel nicht unmittelbar nacheinander, sondern abwechselnd mit den Ausleseschritten eines anderen Pixels, der mit derselben Spaltenleitung verbunden oder verbindbar ist. Somit können Verzögerungen vermieden werden, die beispielsweise aus der benötigten Zeitdauer für Ladungstransfers innerhalb der Pixel resultieren können und die Durchsatzrate des Spaltenbusses begrenzen würden.

Die vorliegende Erfindung bezieht sich auch auf ein Verfahren zum Auslesen eines Bildsensor, insbesondere eines CMOS-Bildsensors, für elektronische Kameras, welcher eine Vielzahl von in Zeilen und Spalten angeordneten lichtempfindlichen Pixeln umfasst, in denen belichtungsabhängige Pixelsignale erzeugt werden, wobei einer jeweiligen Spalte mehrere Spaltenleitungen zugeordnet sind. Das Verfahren ist dadurch gekennzeichnet, dass innerhalb eines Schaltzeitintervalls, in dem eines der Pixelsignale über eine der Spaltenleitungen einer jeweiligen Spalte ausgegeben wird, eine andere der Spaltenleitungen der jeweiligen Spalte mittels einer Vorladeschaltung geladen oder entladen wird.

Bevorzugt wird innerhalb eines anderen Schaltzeitintervalls, in dem ein anderes Pixelsignal über die genannte andere der Spaltenleitungen ausgegeben wird, die genannte eine der Spaltenleitungen mittels einer Vorladeschaltung oder der genannten Vorladeschaltung geladen oder entladen.

Weitere vorteilhafte Ausführungsformen der Erfindung sind in den Unteransprüchen der Beschreibung und den Zeichnungen angegeben.

Die Erfindung wird nachfolgend anhand eines Ausführungsbeispiels mit Bezug auf die Zeichnungen beschrieben. Es zeigen:
- Fig. 1: einen Vier-Transistor-CMOS-Bildsensor gemäß dem Stand der Technik, wobei von dem Bildsensor lediglich ein Pixel und eine der Spaltenleitung des Pixels zugeordnete Spaltenausleseschaltung und eine Vorladeschaltung dargestellt sind;
- Fig. 2: eine schematische Darstellung eines CMOS-Bildsensors mit zwei Spaltenleitungen je Spalte, wobei von dem Bildsensor lediglich ein Teil einer Spalte einschließlich zugeordneter Spaltenausleseschaltungen und Vorladeschaltungen dargestellt ist;
- Fig. 3: eine schematische Darstellung eines CMOS-Bildsensors gemäß der vorliegenden Erfindung in einer zu Fig. 2 analogen Darstellung;
- Fig. 4: eine Ausführungsform einer Umschalteinrichtung;
- Fig. 5: eine Ausführungsform einer Vorladeschaltung;
- Fig. 6A: den zeitlichen Potentialverlauf auf einer Spaltenleitung eines Bildsensors gemäß Fig. 1 bzw. 2;
- Fig. 6B: den zeitlichen Potentialverlauf auf einer Spaltenleitung eines erfindungsgemäßen Bildsensors gemäß Fig. 3 in einer zu Fig. 6A analogen Darstellung;
- Fig. 7A: einen zeitlichen Ablauf des Auslesens von zwei Pixeln einer Spalte bei einem Bildsensor gemäß Fig. 1;
- Fig. 7B: einen zeitlichen Ablauf des Auslesens von zwei Pixeln einer Spalte bei einem Bildsensor gemäß Fig. 2 in einer zu Fig. 7A analogen Darstellung;
- Fig. 7C: einen zeitlichen Ablauf des Auslesens von zwei Pixeln einer Spalte bei einem erfindungsgemäßen Bildsensor gemäß Fig. 3 in einer zu Fig. 7A und 7B analogen Darstellung;
- Fig. 8: einen zeitlichen Ablauf des Auslesens von sechzehn Pixeln einer Spalte bei einem erfindungsgemäßen Bildsensor gemäß Fig. 3;
- Fig. 9: eine schematische Darstellung einer weiteren Ausführungsform eines erfindungsgemäßen Bildsensors, wobei lediglich eine Spalte dargestellt ist; und
- Fig. 10A und 10B: schematische Querschnitte durch verschiedene Anordnungen von Spaltenleitungen einer Spalte bei einem erfindungsgemäßen Bildsensor.

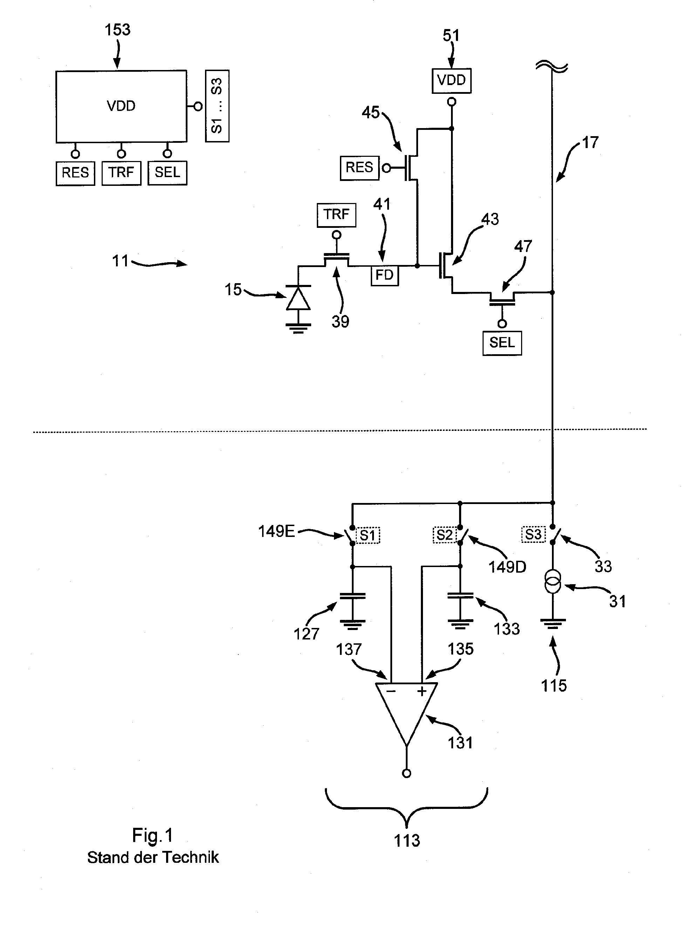

Die grundlegende Funktionsweise eines beispielhaften herkömmlichen Vier-Transistor-Bildsensors des APS-Typs (aktiver Pixelsensor) wird zum besseren Verständnis der Erfindung nachfolgend mit Bezug auf Fig. 1 erläutert, wobei einzelne Komponenten dieses Bildsensors auch bei einem erfindungsgemäßen Bildsensor vorhanden sind. Grundsätzlich ist die vorliegende Erfindung nicht auf aktive Vier-Transistor-Bildsensoren beschränkt, sondern kann auch bei Bildsensoren mit weniger oder mehr als vier Transistoren je Pixel zum Einsatz kommen.

In Fig. 1 ist stellvertretend lediglich ein einziges Pixel 11 dargestellt, welches ein lichtempfindliches Detektorelement in Form einer Photodiode 15 umfasst, insbesondere einer sogenannten Pinned-Diode, die über eine Schalteinrichtung in Form eines Transfer-Gates 39 mit einem Ausleseknoten 41, der insbesondere als eine sogenannte Floating Diffusion (FD) ausgebildet ist, ladungsgekoppelt ist.

Der Ausleseknoten 41 ist mit dem Gate eines als Source-Folger ausgebildeten Wandler-Feldeffekttransistors (FET) 43 verbunden, der eine Ladungs-Spannungs-Wandlerschaltung darstellt. Darüber hinaus ist der Ausleseknoten 41 über eine weitere Schalteinrichtung in Form eines Rücksetz-FETs 45 mit einer positiven Spannungsversorgung 51 verbunden. Einer der beiden Kanalanschlüsse des Wandler-FETs 43 ist ebenfalls mit der positiven Spannungsversorgung 51 verbunden, wohingegen der andere der beiden Kanalanschlüsse des Wandler-FETs 43 über einen Auswahl-FET 47, der als Zeilenauswahlschalter fungiert, mit einer dem dargestellten Pixel zugeordneten Spaltenleitung 17 verbindbar ist, d.h. mit einer zugeordneten elektrischen Verbindungsleitung des Spaltenbusses.

Die Spaltenleitung 17 ist dafür vorgesehen, die in einer zugehörigen Spalte angeordneten Pixel, insbesondere das Pixel 11, mit einer gemeinsamen Spaltenausleseschaltung 113, beispielsweise einer Spaltenverstärkerschaltung, zu verbinden. Die Spaltenausleseschaltung 113 umfasst einen ersten Kondensator oder Referenzwert-Kondensator 127, der mit einem Anschluss gegen Masse geschaltet und mit dem anderen Anschluss über einen Schalter 149E wahlweise mit der Spaltenleitung 17 verbindbar ist. Die Spaltenausleseschaltung 113 umfasst ferner einen zweiten Kondensator oder Signalwert-Kondensator 133, der mit einem Anschluss ebenfalls gegen Masse geschaltet und mit dem anderen Anschluss über einen weiteren Schalter 149D ebenfalls wahlweise mit der Spaltenleitung 17 verbindbar ist.

Darüber hinaus umfasst die Spaltenausleseschaltung 113 einen Verstärker 131, an dessen negativem Eingang 137 die an dem ersten Kondensator 127 anliegende Spannung und an dessen positivem Eingang 135 die an dem zweiten Kondensator 133 anliegende Spannung angelegt wird.

Das Transfer-Gate 39 ist über eine Steuerleitung TRF, der Rücksetz-FET 45 ist über eine Steuerleitung RES, der Auswahl-FET 47 ist über eine Steuerleitung SEL, der Schalter 149E ist über eine Steuerleitung S1 und der Schalter 149D ist über eine Steuerleitung S2 von einer gemeinsamen Steuereinrichtung 153 des Bildsensors steuerbar.

Der Spaltenleitung 17 ist ferner eine Vorladeschaltung 115 zugeordnet, welche eine Stromquelle 31 umfasst, die mittels eines Trennschalters 33 mit der Spaltenleitung 17 wahlweise verbindbar ist. Die Ansteuerung des Trennschalters 33 erfolgt durch die gemeinsame Steuereinrichtung 153 über eine Steuerleitung S3.

Nachfolgend wird das Funktionsprinzip eines derartigen Pixels 11 exemplarisch, basierend auf einer 3,3 V-CMOS-Technologie, beschrieben. Dieses Verfahren wird auch als "Correlated Double Sampling" (CDS) bezeichnet. Typischerweise können alle Pixel in einer Zeile auf die gleiche Weise und insbesondere parallel ausgelesen werden, so dass es für die Beschreibung des Auslesevorgangs ausreicht, nur diejenigen Pixel zu betrachten, die mit derselben Spaltenleitung 17 verbunden sind.

Zunächst wird das während eines Belichtungsvorgangs einfallende Licht durch die Photodiode 15 in elektrische Ladung umgewandelt, sodass sich die Photodiode 15 mit Elektronen füllt. Während des Belichtungsvorgangs werden die Steuerleitungen TRF, RES und SEL jeweils auf 0 V gehalten, d.h. die hierdurch angesteuerten Schalter 39, 45, 47 sind geöffnet.

Vor dem eigentlichen Auslesen wird in einem Schritt P (Pre-Charge oder Vorladen) der Trennschalter 33 zunächst geschlossen und dann, nachdem die Spaltenleitung 17 auf ein definiertes Referenzpotential (hier: Massepotential) gesetzt worden ist, wieder geöffnet. Parallel hierzu wird an die Steuerleitung RES kurzzeitig eine Spannung von 3,3 V angelegt, um durch Leckströme und/oder Streulicht gebildete Ladung aus dem Ausleseknoten 41 zu entfernen, d.h. um den Ausleseknoten 41 zu löschen. Der Ausleseknoten 41 wird also auf einen durch die Spannungsversorgung 51 definierten Referenzwert gesetzt (nachfolgend als Schritt L bezeichnet). An dem Ausgang des Wandler-FETs 43 stellt sich somit eine Spannung ein, die der Ladung an dem gelöschten Ausleseknoten 41 entspricht.

In einem nächsten Schritt R (Lesen eines Referenzwerts) wird an die Steuerleitung SEL eine Spannung von 3,3 V angelegt, sodass der Auswahl-FET 47 geschlossen wird. Zusätzlich wird der Schalter 149E geschlossen. Hierdurch wird der der Ladung im Ausleseknoten 41 entsprechende Spannungswert des Wandler-FETs 43 über den Auswahl-FET 47 auf die Spaltenleitung 17 geschaltet und somit zum Kondensator 127 übertragen. Nachdem das System eingeschwungen ist, wird der Auswahl-FET 47 durch ein entsprechendes Steuersignal wieder geöffnet und gleichzeitig wird der Kondensator 127 durch Öffnen des Schalters 149E wieder von der Spaltenleitung 17 getrennt.

Anschließend wird in einem weiteren Schritt P durch kurzzeitiges Schließen des Trennschalters 33 die Spaltenleitung 17 erneut auf das definierte Referenzpotential vorgeladen. Parallel hierzu wird an die Steuerleitung TRF kurzzeitig eine Spannung von 3,3 V angelegt, um das Transfer-Gate 39 kurzzeitig zu öffnen, sodass die belichtungsabhängig erzeugten Elektronen von der Photodiode 15 zu dem Ausleseknoten 41 fließen können (nachfolgend als Schritt T bezeichnet).

In einem nächsten Schritt S (Lesen eines Signalwerts) werden der Auswahl-FET 47 und der Schalter 149D geschlossen. Hierdurch wird der der Ladung im Ausleseknoten 41 entsprechende Spannungswert des Wandler-FETs 43 über den Auswahl-FET 47 auf die Spaltenleitung 17 geschaltet und somit zum Kondensator 133 übertragen. Nachdem das System eingeschwungen ist, wird der Kondensator 133 durch Öffnen des Schalters 149D wieder von der Spaltenleitung 17 getrennt. Durch Anlegen von 0 V an die Steuerleitung SEL wird auch der Auswahl-FET 47 geöffnet und das Pixel 11 von der Spaltenleitung 17 getrennt.

Am Ausgang des Verstärkers 131 liegt nun eine Spannung an, die der Differenz der in den Kondensatoren 127, 133 gespeicherten Spannungswerte und damit der in der Photodiode 15 erzeugten Ladungsmenge entspricht.

Schließlich kann in noch einem weiteren Schritt eine Spannung von 3,3 V kurzzeitig an die Steuerleitungen RES und TRF angelegt werden, um die Ladung aus dem Ausleseknoten 41 und eventuelle Restladung aus der Photodiode 15 zu entfernen, damit der nächste Belichtungsvorgang wieder mit einem völlig "leeren" Pixel beginnen kann.

Diese Schritte werden auch für die weiteren, mit der jeweiligen Spaltenleitung 17 verbundenen Pixel durchgeführt.

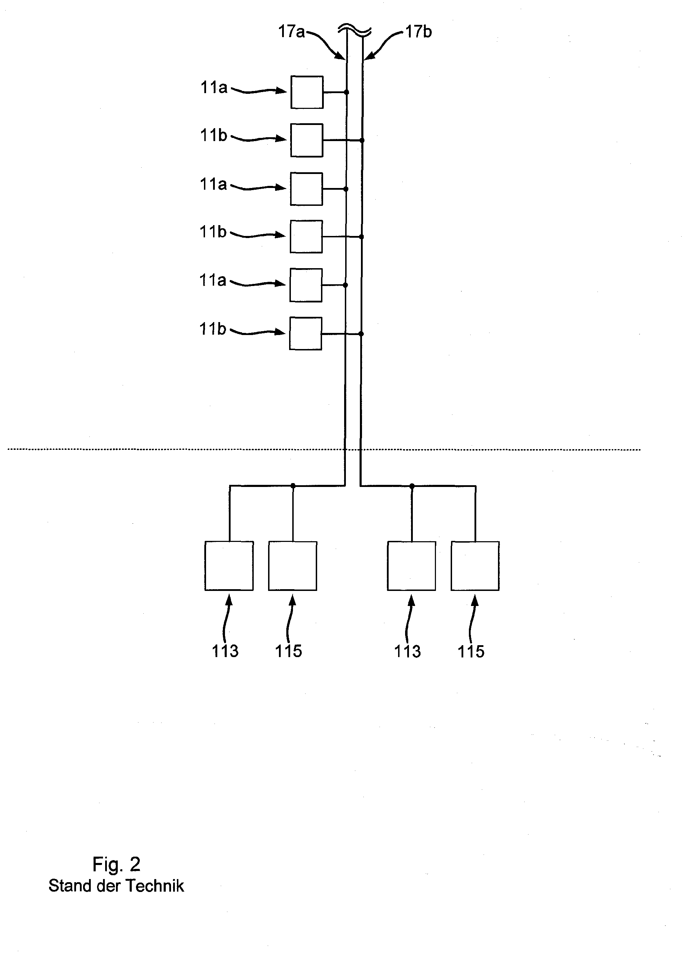

Ein weiterer herkömmlicher Bildsensor umfasst gemäß Fig. 2, im Unterschied zum Bildsensor von Fig. 1, für jede Spalte zwei Spaltenleitungen 17a, 17b. Den Spaltenleitungen 17a, 17b sind eine jeweilige Spaltenausleseschaltung 113 sowie eine jeweilige Vorladeschaltung 115 zugeordnet. Der Spaltenleitung 17a sind eine Vielzahl von Pixeln 11a und der Spaltenleitung 17b eine Vielzahl von Pixeln 11b zugeordnet, wobei in der Spalte jeweils abwechselnd ein Pixel 11a und ein Pixel 11b angeordnet ist. Die jeweilige Spaltenleitung 17a, 17b ist wahlweise mit einem der zugeordneten Pixel 11a, 11b verbindbar, wobei die hierfür vorgesehenen Zeilenauswahlschalter (z.B. Auswahl-FET 47 gemäß Fig. 1) in Fig. 2 nicht gezeigt sind. Die Spaltenausleseschaltungen 113 und die Vorladeschaltungen 115 sind analog zu der Spaltenausleseschaltung 113 bzw. der Vorladeschaltung 115 von Fig. 1 ausgestaltet.

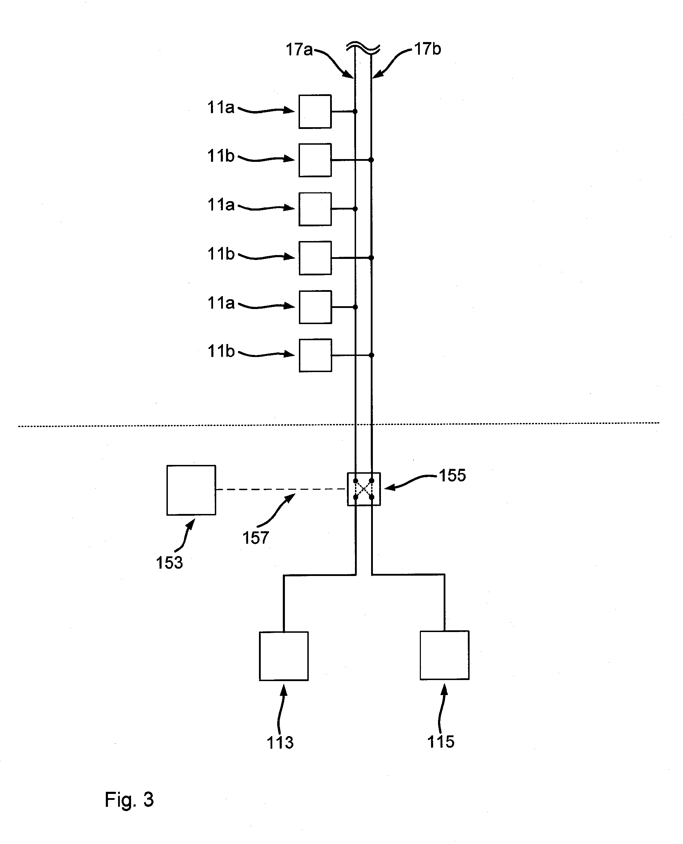

Fig. 3 zeigt nun einen erfindungsgemäßen Bildsensor, bei dem die Zuordnung von Pixeln 11a, 11b zu Spaltenleitungen 17a, 17b dem herkömmlichen Bildsensor von Fig. 2 entspricht. Die Pixel 11a der gezeigten Spalte sind also lediglich mit der einen Spaltenleitung 17a und die Pixel 11b lediglich mit der anderen Spaltenleitung 17b über die genannten Zeilenauswahlschalter verbindbar.

Im Unterschied zu Fig. 2 sind für die beiden Spaltenleitungen 17a, 17b der jeweiligen Spalte nur eine Spaltenausleseschaltung 113 und eine Vorladeschaltung 115 vorgesehen, welche beispielsweise wie in Fig. 1 ausgestaltet sein können. Hierbei sind die Spaltenleitungen 17a, 17b mit der Spaltenausleseschaltung 113 und der Vorladeschaltung 115 über eine Umschalteinrichtung 155 verbindbar, welche in diesem Ausführungsbeispiel vereinfacht als Kreuzschalter dargestellt ist. Die Funktionalität dieses Kreuzschalters kann alternativ auch durch eine entsprechende Anordnung von zwei Wechselschaltern oder vier Einzelschaltern bereitgestellt werden, die auf entsprechende Weise angesteuert werden. Die Ansteuerung der Umschalteinrichtung 155 erfolgt durch die mit Bezug auf Fig. 1 bereits erläuterte Steuereinrichtung 153 über eine Steuerleitung 157.

Mittels der Umschalteinrichtung 155 kann in einem ersten Schaltzustand die Spaltenleitung 17a mit der Vorladeschaltung 115 und die Spaltenleitung 17b mit der Spaltenausleseschaltung 113 verbunden werden (Kreuzschaltzustand in Fig. 3). In einem zweiten Schaltzustand werden die Verbindungen vertauscht, d.h. die Spaltenleitung 17a ist mit der Spaltenausleseschaltung 113 und die Spaltenleitung 17b ist mit der Vorladeschaltung 115 verbunden (Parallelschaltzustand in Fig. 3).

Da auf der einen Spaltenleitung (z.B. 17a) somit lediglich ein Vorladevorgang stattfindet, während auf der anderen Spaltenleitung (z.B. 17b) ein Auslesevorgang erfolgt, wird ein auf kapazitiver Kopplung beruhendes Übersprechen zwischen den unmittelbar oder indirekt benachbarten Spaltenleitungen 17a, 17b vermieden.

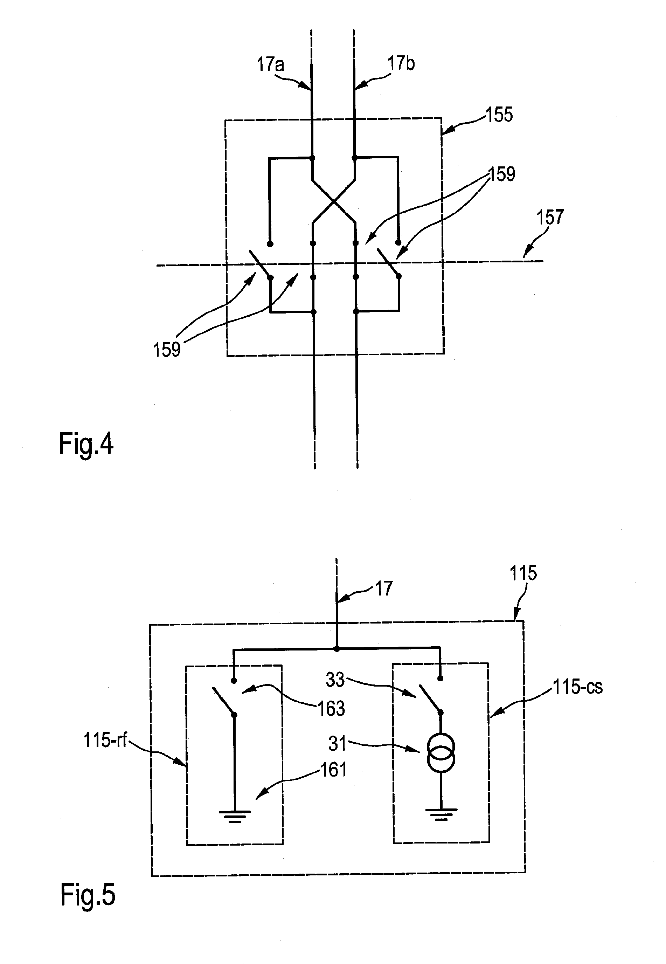

Fig. 4 zeigt eine mögliche Ausführungsform der Umschalteinrichtung 155 gemäß Fig. 3 (in einem Kreuzschaltzustand) mit vier Einzelschaltern 159, die über eine einzige gemeinsame Steuerleitung 157 angesteuert werden.

Fig. 5 zeigt eine mögliche Ausführungsform einer Vorladeschaltung 115 des Bildsensors gemäß Fig. 3. Die Vorladeschaltung 115 umfasst eine Vorladeschaltung 115-cs und eine weitere Vorladeschaltung 115-rf in einer parallelen Anordnung. Die Vorladeschaltung 115-cs und die weitere Vorladeschaltung 115-rf können über eine Umschalteinrichtung (nicht gezeigt) mit derselben Spaltenleitung 17 oder mit zwei verschiedenen Spaltenleitungen (nicht gezeigt) verbunden sein. Die Vorladeschaltung 115-cs umfasst eine Stromquelle 31 und einen steuerbaren Trennschalter 33 (analog zu der Vorladeschaltung 115 gemäß Fig. 1). Die weitere Vorladeschaltung 115-rf umfasst eine Referenzpotentialquelle 161 und einen weiteren steuerbaren Trennschalter 163.

Die Steuereinrichtung 153 des Bildsensors (Fig. 3) ist angepasst, zum Koppeln einer jeweiligen Spaltenleitung 17a oder 17b (Fig. 3) mit der Vorladeschaltung 115 zunächst den Trennschalter 33 der Vorladeschaltung 115-cs zu schließen und den weiteren Trennschalter 163 der weiteren Vorladeschaltung 115-rf zu öffnen, um die Spaltenleitung 17a, 17b mit der Stromquelle 31 zu koppeln. Hierdurch wird die Spaltenleitung 17a, 17b auf das erwünschte elektrische Potential (Referenzpotential) geladen oder entladen. Danach öffnet die Steuereinrichtung 153 den Trennschalter 33 und schließt den weiteren Trennschalter 163, um die jeweilige Spaltenleitung 17a, 17b mit der Referenzpotentialquelle 161 zu koppeln. Hierdurch wird die Spaltenleitung 17a, 17b auf dem Referenzpotential gehalten. Nach Ablauf des erwünschten Schaltzeitintervalls öffnet die Steuereinrichtung 153 auch den weiteren Trennschalter 163 wieder. Danach kann die Steuereinrichtung 153 die Umschalteinrichtung 155 (Fig. 3) ansteuern, um den Schaltzustand zu wechseln, d.h. um die auf das Referenzpotential geladene oder entladene Spaltenleitung 17a oder 17b mit der Spaltenausleseschaltung 113 zu koppeln. Nun kann über die jeweilige Spaltenleitung 17a, 17b ein Pixelsignal an die Spaltenausleseschaltung 113 übertragen werden (wie im Zusammenhang mit Fig. 1 erläutert, z.B. durch kurzzeitiges Schließen des Auswahl-FETs 47).

Die Trennschalter 33 und 163 gemäß Fig. 5 ermöglichen eine Verbindung der jeweiligen Spaltenleitung 17a oder 17b mit der Stromquelle 31 und der Referenzpotentialquelle 161 unabhängig von der Umschalteinrichtung 155. Alternativ können bei einem erfindungsgemäßen Bildsensor die Referenzpotentialquelle 161 und die Trennschalter 33, 163 der Vorladeschaltung 115 auch entfallen. In diesem Fall wird die Zeitdauer des Pre-Charge alleine durch die Umschalteinrichtung 155 bestimmt.

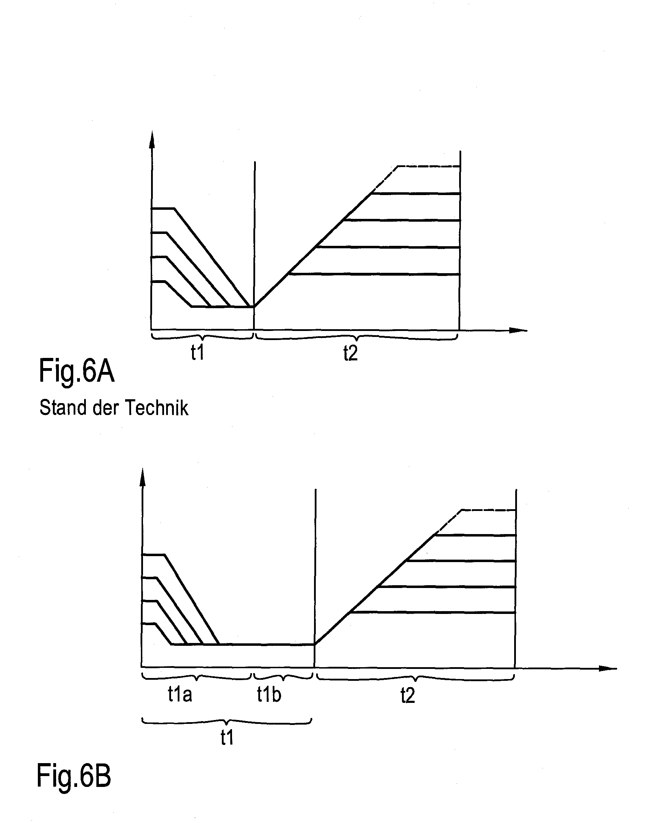

In Fig. 6A ist der zeitliche Verlauf des elektrischen Potentials auf den Spaltenleitungen 17 bzw. 17a, 17b dargestellt, wie er typischerweise bei herkömmlichen Bildsensoren gemäß Fig. 1 oder 2 auftritt. Während eines Zeitraums t1, welcher dem vorstehend beschriebenen Vorlade-Schritt P entspricht, fällt das Potential auf den Spaltenleitungen 17, 17a, 17b kontinuierlich auf ein durch das Massepotential vorgegebenes Referenzpotential ab, wobei die Zeit, in der dieses Referenzpotential erreicht wird, von dem vorherigen Ausgangspotential auf den Spaltenleitungen 17, 17a, 17b abhängt. Dies ist durch die Kurvenschar illustriert, die in Fig. 6A im linken Teil gezeigt ist. Während eines nachfolgenden Zeitraums t2, welcher den vorstehend beschriebenen Ausleseschritten R oder S entspricht, steigt das Potential auf den Spaltenleitungen 17, 17a, 17b auf ein Signalpotential an, welches der im Ausleseknoten 41 (Fig. 1) vorhandenen Ladung entspricht (im rechten Teil von Fig. 6A wiederum als Kurvenschar illustriert). In der Regel wird ein herkömmlicher Bildsensor so angesteuert, dass der Zeitraum t2 (Einschwingen der Signalspannung) länger als der Zeitraum t1 ist (Vorladen).

Ein beispielhafter zeitlicher Verlauf für einen erfindungsgemäßen Bildsensor (z.B. gemäß Fig. 3) ist in Fig. 6B dargestellt. Dieser zeitliche Verlauf unterscheidet sich von jenem gemäß Fig. 6A im Wesentlichen darin, dass der Zeitraum t1 für den Vorlade-Schritt P gleich lang ist wie der Zeitraum t2 für die Ausleseschritte R oder S. Der gezeigte zeitliche Verlauf bezieht sich beispielsweise auf die Spaltenleitung 17a gemäß Fig. 3. Der Zeitraum t1 entspricht in diesem Fall einem Schaltzeitintervall, in dem die Umschalteinrichtung 155 den im Zusammenhang mit Fig. 3 genannten ersten Schaltzustand einnimmt, in dem die Spaltenleitung 17a mit der Vorladeschaltung 115 verbunden ist. Der Zeitraum t2 entspricht in diesem Fall einem Schaltzeitintervall, in dem die Umschalteinrichtung 155 den im Zusammenhang mit Fig. 3 genannten zweiten Schaltzustand einnimmt, in dem die Spaltenleitung 17a mit der Spaltenausleseschaltung 113 verbunden ist.

Zusätzlich ist in Fig. 6B gezeigt, dass der Zeitraum t1 für den Vorlade-Schritt P ferner in zwei Vorladeintervalle t1a, t1b unterteilt sein kann, falls die Vorladeschaltung 115 eine Vorladeschaltung 115-cs und eine weitere Vorladeschaltung 115-rf umfasst wie im Zusammenhang mit Fig. 5 erläutert. In einem ersten Vorladeintervall t1a ist durch temporäres Schließen des Trennschalters 33 die Vorladeschaltung 115-cs (Stromquelle 31) wirksam, um die Spaltenleitung (z.B. 17a) auf das Referenzpotential zu laden oder zu entladen. Die Dauer des ersten Vorladeintervalls t1a kann entsprechend der maximal benötigten Dauer für das Vorladen gewählt sein. In einem zweiten Vorladeintervall tlb ist durch temporäres Schließen des weiteren Trennschalters 163 die weitere Vorladeschaltung 115-rf (Referenzpotentialquelle 161) wirksam, um die Spaltenleitung (z.B. 17a) auf dem Referenzpotential zu halten.

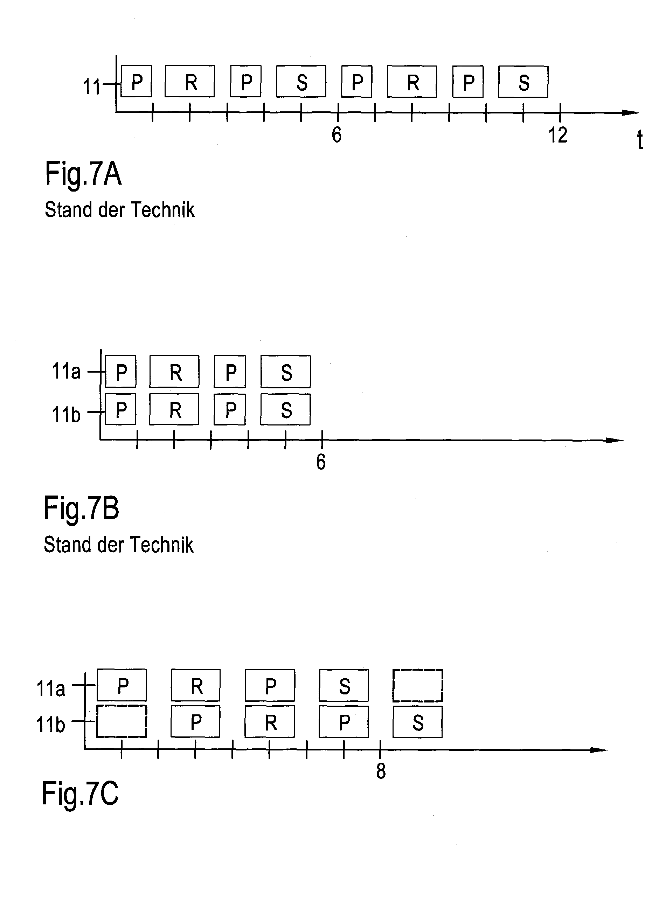

Da bei Fig. 6B der Zeitraum t1 für den Vorlade-Schritt P gleich lang ist wie der Zeitraum t2 für die Ausleseschritte R oder S, erstreckt sich das Laden oder Entladen der Spaltenleitungen auf das Referenzpotential bei dem erfindungsgemäßen Bildsensor über einen längeren Zeitraum als bei einem herkömmlichen Bildsensor. Dennoch ist der Zeitraum zum Auslesen von zwei Pixeln im Vergleich zu einem herkömmlichen Bildsensor gemäß Fig. 1, welcher pro Spalte eine Spaltenleitung und eine Spaltenausleseschaltung aufweist, wesentlich verkürzt. Gegenüber einem Bildsensor gemäß Fig. 2 mit zwei Spaltenleitungen, denen jeweils eine eigene Spaltenausleseschaltung und Vorladeschaltung zugeordnet ist, ergibt sich jedoch nur eine geringfügige Verlängerung des entsprechenden Zeitraums. Dies wird nachfolgend anhand der jeweiligen in Fig. 7A bis 7C vereinfacht dargestellten zeitlichen Abläufe näher erläutert, die sich beim Auslesen von zwei Pixeln einer Spalte ergeben.

Fig. 7A zeigt diesen zeitlichen Ablauf für einen Sensor mit nur einer Spaltenleitung 17, wie er mit Bezug auf Fig. 1 beschrieben wurde. Der Schritt P (Vorladen), der Schritt R (Lesen eines Referenzwerts) und der Schritt S (Lesen eines Signalwerts) sind durch Blöcke unterschiedlicher Länge repräsentiert, welche durch entsprechende Symbole P, R und S gekennzeichnet sind. Die unterschiedlichen Schaltzeiten t1, t2 für den Schritt P einerseits und für die Schritte R und S andererseits (Fig. 6A) sind durch unterschiedliche Längen der Blöcke in Richtung der Zeitachse t illustriert. Vereinfacht beträgt die relative Zeiteinheit für den Schritt P eine Einheit, während die relative Zeitdauer für die Schritte R und S zwei Zeiteinheiten beträgt. Demnach beträgt die Zeitdauer für einen Auslesezyklus eines Pixels, der das Auslesen eines Referenzwerts und eines Signalwerts einschließlich der zugehörigen Vorlade-Vorgänge der Spaltenleitungen umfasst, sechs Zeiteinheiten. Da die zwei Pixel sequentiell ausgelesen werden, werden insgesamt zwölf Zeiteinheiten benötigt.

Bei einem Bildsensor gemäß Fig. 2 mit zwei Spaltenleitungen, denen jeweils eine eigene Spaltenausleseschaltung und Vorladeschaltung zugeordnet sind, werden zwei zueinander benachbarte Pixel 11a und 11b parallel ausgelesen. Ein entsprechender zeitlicher Ablauf ist in Fig. 7B dargestellt, wobei der Schritt P und die Schritte R und S jeweils die gleiche Länge wie in Fig. 7A aufweisen. Demnach beträgt die Zeitdauer für einen Auslesezyklus eines Pixels ebenfalls sechs Zeiteinheiten. Da die zwei Pixel parallel zueinander ausgelesen werden, werden insgesamt lediglich sechs Zeiteinheiten benötigt. Dem Vorteil des schnellen Auslesens steht hier jedoch der Nachteil des größeren Platzbedarfs für die zusätzliche Spaltenausleseschaltung und Vorladeschaltung gegenüber (Spaltenausleseschaltungen 113 und Vorladeschaltungen 115 gemäß Fig. 2).

In Fig. 7C ist analog zu Fig. 7A und 7B der zeitliche Ablauf des Auslesens für einen erfindungsgemäßen Bildsensor beispielsweise gemäß Fig. 3 dargestellt. Die Zeitdauer für einen Vorlade-Schritt P beträgt hierbei ebenso wie für einen Ausleseschritt R oder S zwei Zeiteinheiten. Wie in Fig. 7C zu erkennen ist, erfolgt ein Vorlade-Schritt P alternierend für die Pixel 11a und 11b. Entsprechend erfolgt auch ein Ausleseschritt R oder S alternierend für die Pixel 11a und 11b. Während also eines der Pixel 11a über die Spaltenleitung 17a ausgelesen wird, wird gleichzeitig die mit einem der Pixel 11b verbundene Spaltenleitung 17b mittels der Vorladeschaltung 113 vorgeladen (vgl. Fig. 3), und umgekehrt. Somit benötigt ein Auslesezyklus für beide Pixel 11a, 11b einschließlich der notwendigen Vorlade-Zeiten insgesamt acht Zeiteinheiten, wobei eine gewisse Verschränkung von jeweils zwei Zeiteinheiten mit einem vorhergehenden und einem nachfolgenden Auslesezyklus der jeweiligen Spalte besteht. Der Auslesezyklus für die zwei Pixel 11a, 11b dauert also etwas länger als in Fig. 7B. Allerdings werden hierfür lediglich eine einzige Spaltenausleseschaltung 113 und eine einzige Vorladeschaltung 115 benötigt (vgl. Fig. 3), gegenüber den zwei Spaltenausleseschaltungen 113 und zwei Vorladeschaltungen 115 für jede Spalte gemäß Fig. 2.

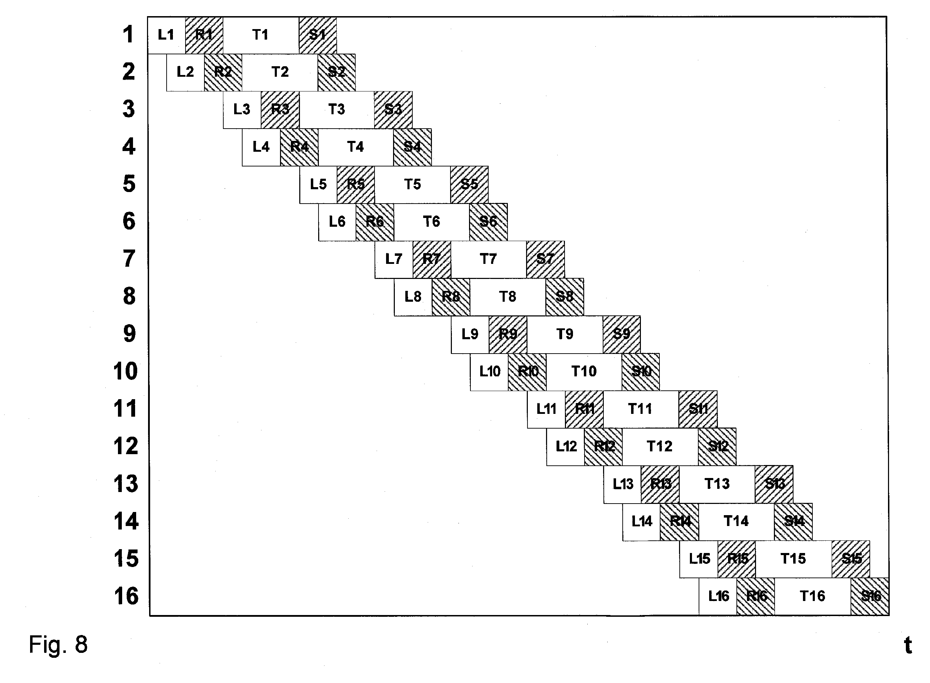

Fig. 8 zeigt einen weiteren möglichen Zeitverlauf des Auslesens von beispielsweise sechzehn Pixeln einer Spalte bei einem erfindungsgemäßen Bildsensor gemäß Fig. 3. Bei dieser Ausführungsform sind der jeweiligen Spalte zwei Spaltenleitungen 17a, 17b zugeordnet, wobei das erläuterte Prinzip sich auch auf eine höhere Anzahl von Spaltenleitungen (z.B. vier) übertragen lässt. Generell ist lediglich wichtig, dass für einen einzigen Belichtungsvorgang des Bildsensors in jedem der Pixel mehrere Ausleseschritte durchgeführt werden (z.B. ein Referenzwert und ein Signalwert, oder ein erster Signalwert und ein zweiter Signalwert). In Fig. 8 sind die sechzehn Pixel (d.h. Zeilen) der jeweiligen Spalte auf der linken Seite und zusätzlich in den verschiedenen Schritten mit den Ziffern 1 bis 16 bezeichnet. Aufgrund der alternierenden Verbindung der Pixel mit den zwei Spaltenleitungen 17a, 17b gemäß Fig. 3 ergibt sich, dass in Fig. 8 die ungeradzahlig bezeichneten Pixel (1, 3, 5, ...) mit der einen Spaltenleitung 17a und die geradzahlig bezeichneten Pixel (2, 4, 6, ...) mit der anderen Spaltenleitung 17b verbunden sind.

Zusätzlich zu dem Schritt R (Lesen eines Referenzwerts) und dem Schritt S (Lesen eines Signalwerts) sind in Fig. 8 die Schritte L und T gezeigt. Der Schritt L bezeichnet, wie im Zusammenhang mit Fig. 1 erläutert, ein Löschen des Ausleseknotens 41 des jeweiligen Pixels. Der Schritt T bezeichnet ein Transferieren der belichtungsabhängig erzeugten Ladung von der Photodiode 15 zu dem Ausleseknoten 41 des jeweiligen Pixels. Dieser Pixel-interne Transfer der Ladung benötigt in der Regel eine Zeitdauer, die länger ist als die für die den jeweiligen Schritt L, R und S erforderliche Zeitdauer. Falls die Zeitdauer für den Ladungstransfer zu kurz gewählt wird, erfolgt nur ein unvollständiger Transfer, was zu Bildartefakten führt. Daher ist bei dem in Fig. 8 gezeigten Beispiel für jeden der Schritte L, R und S ein Arbeitstakt vorgesehen, während für den Transfer-Schritt T zwei Arbeitstakte vorgesehen sind. Dies ist in Fig. 8 (ähnlich wie in Fig. 7C) durch Blöcke unterschiedlicher Länge dargestellt.

Der besseren Übersicht halber ist in Fig. 8 der jeweilige Schritt P gemäß Fig. 7C, also das Vorladen der Spaltenleitung 17a, 17b vor dem eigentlichen Auslesen des Referenzwerts oder des Signalwerts, nicht dargestellt. Stattdessen umfasst der gezeigte jeweilige Schritt R bei der Darstellungsweise gemäß Fig. 8 in der ersten Hälfte das Vorladen der Spaltenleitung 17a oder 17b und in der zweiten Hälfte das Lesen des Referenzwerts über diese Spaltenleitung 17a, 17b. Der gezeigte jeweilige Schritt S umfasst in der ersten Hälfte das Vorladen und in der zweiten Hälfte das Lesen des Signalwerts.

Eine Besonderheit des in Fig. 8 gezeigten Zeitverlaufs des Auslesens der sechzehn Pixeln besteht darin, dass zum einen eine ausreichend lange Zeitdauer für den Ladungstransfer innerhalb des jeweiligen Pixels (Schritt T) vorgesehen ist, und dass zum anderen durch eine Verschränkung der für verschiedene Pixel durchgeführten Ausleseschritte die insgesamt benötigte Zeitdauer zum Auslesen aller Pixel kurz gehalten wird. Somit wird eine hohe Bildrate ermöglicht.

Hierfür steuert die Steuereinrichtung 153 den Bildsensor derart, dass für einen einzigen Belichtungsvorgang des Bildsensor in einem ersten der Pixel mehrere Ausleseschritte durchgeführt werden (Schritt R und Schritt S einschließlich des jeweiligen Vorladens der zugeordneten Spaltenleitung), um mehrere Pixelsignale des ersten Pixels nacheinander zu erzeugen und an eine der zwei Spaltenleitungen 17a oder 17b auszugeben. Ferner werden für denselben Belichtungsvorgang auch in einem zweiten der Pixel mehrere Ausleseschritte (R und S) durchgeführt, um mehrere Pixelsignale dieses zweiten Pixels nacheinander zu erzeugen und an dieselbe der zwei Spaltenleitungen 17a, 17b auszugeben. Hierbei sorgt die Steuereinrichtung 153 dafür, dass zwischen den Ausleseschritten des ersten Pixels wenigstens ein Ausleseschritt des zweiten Pixels durchgeführt wird.

Beispielsweise ist gemäß Fig. 8 für die mit der Spaltenleitung 17a (Fig. 3) verbundenen Pixel (ungeradzahlig bezeichnete Pixel) die folgende Abfolge von Ausleseschritten vorgesehen: R1, R3, S1, R5, S3, R7, S5, R9, S7, R11, S9, etc. Zwischen den Ausleseschritten R, S können in den Pixeln auch die Schritte L (Löschen des Ausleseknotens) und T (Transferieren der Ladung zum Ausleseknoten) durchgeführt werden, wie in Fig. 8 gezeigt.

Es ist von besonderem Vorteil, dass für die verschränkten Ausleseschritte R, S (einschließlich des jeweiligen Vorladens der zugeordneten Spaltenleitung) gemäß Fig. 8 die jeweilige Spaltenleitung (17a oder 17b) sehr effizient ausgenutzt wird. Dies wird bei Betrachtung der Fig. 8 entlang einer vertikalen Richtung deutlich. Die Belegung der jeweiligen Spaltenleitung 17a, 17b durch einen Ausleseschritt R, S ist in Fig. 8 nämlich durch eine Schraffur des jeweiligen Ausleseschritts illustriert, wobei für die mit der einen Spaltenleitung 17a verbundenen Pixel und für die mit der anderen Spaltenleitung 17b verbundenen Pixel unterschiedliche Schraffuren gewählt sind. Abgesehen von dem Auslesen der ersten und letzten Zeilen wird die jeweilige Spaltenleitung 17a, 17b zu jedem Zeitpunkt genutzt, nämlich für jeden Ausleseschritt R, S erst zum Vorladen und danach zum Übertragen des Referenzwerts oder des Signalwerts. Zu keinem Zeitpunkt erfolgt hingegen eine Doppelbelegung der jeweiligen Spaltenleitung 17a, 17b (vgl. die unterschiedliche Schraffuren). Anhand von Fig. 8 ist auch ersichtlich, dass durch entsprechende Ansteuerung der Umschalteinrichtung 155 (Fig. 3) eine einzige Vorladeschaltung 115 und eine einzige Spaltenausleseschaltung 113 für die zwei Spaltenleitungen 17a, 17b ausreichend sind. Zu jedem Zeitpunkt muss nämlich nur eine der zwei Spaltenleitungen 17a, 17b vorgeladen und nur eine der zwei Spaltenleitungen 17a, 17b ausgelesen werden (vgl. Anordnung der ersten Hälften der Ausleseschritte R, S und Anordnung der zweiten Hälften der Ausleseschritte R, S).

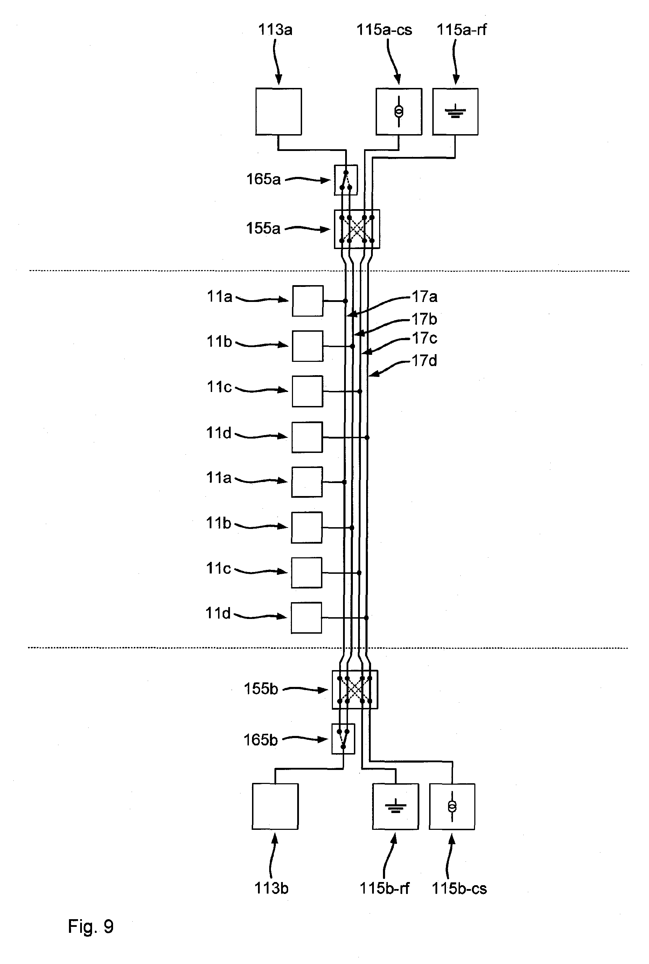

Fig. 9 zeigt eine weitere Ausführungsform eines erfindungsgemäßen Bildsensors. Bei dieser Ausführungsform sind einer jeweiligen Spalte von Pixeln 11 (vorzugsweise jeder Spalte des Bildsensors) vier Spaltenleitungen zugeordnet, nämlich zwei erste Spaltenleitungen 17a, 17b und zwei zweite Spaltenleitungen 17c, 17d. Die Pixel 11a sind mit einer (17a) der zwei ersten Spaltenleitungen, die Pixel 11b mit der anderen (17b) der zwei ersten Spaltenleitungen, die Pixel 11c mit einer (17c) der zwei zweiten Spaltenleitungen, und die Pixel 11d mit der anderen (17d) der zwei zweiten Spaltenleitungen verbindbar. Hierfür sind Zeilenauswahlschalter vorgesehen (z.B. Auswahl-FET 47 gemäß Fig. 1), die in Fig. 9 nicht gezeigt sind. Die Zuordnung der Pixel 11a, 11b, 11c und 11d zu den verschiedenen Spaltenleitungen 17a, 17b, 17c und 17d ist vorzugsweise gemäß einer zyklischen Reihenfolge gewählt, beispielsweise wie in Fig. 9 gezeigt oder gemäß einem anderen Muster.

Der gezeigten Spalte sind an einem ersten Ende der Spalte (z.B. an einem oberen Rand des Bildfelds) eine erste Spaltenausleseschaltung 113a, eine erste Vorladeschaltung 115a-cs, eine weitere erste Vorladeschaltung 115a-rf und eine erste Umschalteinrichtung 155a zugeordnet. Ferner ist ein erster Auswahlschalter 165a zwischen der ersten Umschalteinrichtung 155a und der ersten Spaltenausleseschaltung 113a angeordnet. An einem dem ersten Ende gegenüber liegenden zweiten Ende der Spalte (z.B. an einem unteren Rand des Bildfelds) sind der Spalte eine zweite Spaltenausleseschaltung 113b, eine zweite Vorladeschaltung 115b-cs, eine weitere zweite Vorladeschaltung 115b-rf und eine zweite Umschalteinrichtung 155b zugeordnet. Ferner ist ein zweiter Auswahlschalter 165b zwischen der zweiten Umschalteinrichtung 155b und der zweiten Spaltenausleseschaltung 113b angeordnet.

Die Ansteuerung der Umschalteinrichtungen 155a, 155b und der Auswahlschalter 165a, 165b erfolgt durch eine mit Bezug auf Fig. 1 bereits erläuterte Steuereinrichtung (in Fig. 9 nicht gezeigt) ähnlich wie bei Fig. 3. Allerdings sind die beiden Umschalteinrichtungen 155a, 155b hier für die Spaltenleitungen 17a, 17b, 17c, 17d paarweise wirksam, und die beiden Umschalteinrichtungen 155a, 155b werden synchron zueinander angesteuert. Dies bedeutet, dass in einem ersten Schaltzustand der beiden Umschalteinrichtungen 155a, 155b die zwei ersten Spaltenleitungen 17a, 17b beispielsweise mit den ersten und zweiten Vorladeschaltungen 115a-cs, 115b-cs an den beiden Enden der Spalte gekoppelt sind, und dass in dem ersten Schaltzustand die zwei zweiten Spaltenleitungen 17c, 17d mit den Spaltenausleseschaltungen 113a, 113b gekoppelt sind (Kreuzschaltzustand in Fig. 9). Die Auswahlschalter 165a, 165b werden hierbei synchron zueinander derart angesteuert, dass die eine (z.B. 17a) der zwei ersten Spaltenleitungen natürlich nur mit einer der zwei Spaltenausleseschaltungen 113a, 113b gekoppelt ist und die andere (z.B. 17b) der zwei ersten Spaltenleitungen nur mit der anderen der zwei Spaltenausleseschaltungen 113a, 113b gekoppelt ist. In dem zweiten Schaltzustand der beiden Umschalteinrichtungen 155a, 155b sind die zwei ersten Spaltenleitungen 17a, 17b mit den Spaltenausleseschaltungen 113a, 113b gekoppelt, und die zwei zweiten Spaltenleitungen 17c, 17d sind mit den ersten und zweiten Vorladeschaltungen 115a-cs, 115b-cs gekoppelt (Parallelschaltzustand in Fig. 9).

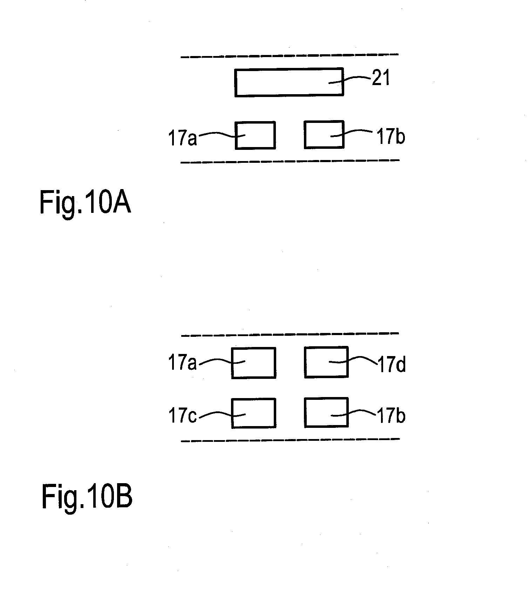

Da somit auf einigen Spaltenleitungen (z.B. 17a, 17b) lediglich ein Vorladevorgang stattfindet, während auf den anderen Spaltenleitungen (z.B. 17c, 17d) ein Auslesevorgang erfolgt, wird ein auf kapazitiver Kopplung beruhendes Übersprechen zwischen den Spaltenleitungen (z.B. zwischen 17a und 17b oder zwischen 17a und 17c) vermieden. Dies gilt insbesondere, wenn die vier Spaltenleitungen 17a, 17b, 17c, 17d wie in Fig. 10B gezeigt angeordnet sind.

Eine Besonderheit des Bildsensors gemäß Fig. 9 liegt auch in den (optionalen) Auswahlschaltern 165a, 165b, die als Spaltenleitungs-Auswahlschalter dienen. Die zwei Auswahlschalter 165a, 165b können wahlweise einen ersten Schaltzustand oder einen zweiten Schaltzustand einnehmen. Die genannte Steuereinrichtung steuert die zwei Auswahlschalter 165a, 165b synchron zueinander, jedoch unabhängig von dem jeweiligen Schaltzustand der zwei Umschalteinrichtungen 155a, 155b. Beispielsweise kann der erste Auswahlschalter 165a entweder den ersten Schaltzustand oder den zweiten Schaltzustand einnehmen, während die erste Umschalteinrichtung 155a den ersten Schaltzustand einnimmt. Für das Auslesen verschiedener Pixel ändert die Steuereinrichtung den jeweiligen Schaltzustand der beiden Auswahlschalter 165a, 165b einer jeweiligen Spalte gemäß einem regelmäßigen oder unregelmäßigen Schaltmuster (z.B. zufällig oder quasi-zufällig). Somit kann jeder Pixel 11 der Spalte wahlweise von der ersten Spaltenausleseschaltung 113a (d.h. nach oben) oder von der zweiten Spaltenausleseschaltung 113b (d.h. nach unten) ausgelesen werden.

Hierdurch kann ein Streifenmuster in einem von dem Bildsensor aufgenommenen Bild vermieden werden, das ansonsten dadurch entstehen könnte, dass die Eigenschaften der ersten Spaltenausleseschaltungen 113a und die Eigenschaften der zweiten Spaltenausleseschaltungen 113b voneinander abweichen (beispielsweise wegen herstellungsbedingt unterschiedlicher Verstärkungsfaktoren). Durch das Variieren der Zuordnung der Pixel 11 zu der ersten Spaltenausleseschaltung 113a oder der zweiten Spaltenausleseschaltung 113b wird letztlich ein Punktemuster erzeugt, das im Vergleich zu einem Streifenmuster vom menschlichen Auge nicht oder kaum erkennbar ist. Die Steuereinrichtung kann den Schaltzustand der zwei Auswahlschalter 165a, 165b beispielsweise zwischen dem Auslesen von Pixelsignalen der Pixel 11 von verschiedenen Zeilen variieren, und/oder zwischen dem Auslesen von Pixelsignalen der Pixel 11 von verschiedenen Bildern einer Sequenz von Bildern.

Eine weitere Besonderheit des Bildsensors gemäß Fig. 9 liegt in der (optionalen) Anordnung der weiteren ersten und zweiten Vorladeschaltungen 115a-rf, 155b-rf an beiden Enden der jeweiligen Spalte. Die erste Vorladeschaltung 115a-cs und die zweite Vorladeschaltung 115b-cs umfassen (entsprechend der Vorladeschaltung 115-cs gemäß Fig. 5) eine jeweilige Stromquelle und einen steuerbaren Trennschalter. Die weitere erste Vorladeschaltung 115a-rf und die weitere zweite Vorladeschaltungen 115b-rf umfassen (entsprechend der weiteren Vorladeschaltung 115-rf gemäß Fig. 5) eine jeweilige Referenzpotentialquelle und einen weiteren steuerbaren Trennschalter. Hierdurch kann die jeweilige Spaltenleitung 17a, 17b, 17c oder 17d zunächst auf ein Referenzpotential geladen und danach auf dem Referenzpotential gehalten werden, wie im Zusammenhang mit Fig. 5 und Fig. 6B erläutert. Wie aus Fig. 9 ersichtlich ist, sind allerdings die Anordnung der ersten Vorladeschaltung 115a-cs und der weiteren ersten Vorladeschaltung 115a-rf an dem ersten Ende der Spalte und die Anordnung der zweiten Vorladeschaltung 115b-cs und der weiteren zweiten Vorladeschaltung 115b-rf an dem zweiten Ende der Spalte relativ zueinander vertauscht. Hierdurch ist es ausreichend, an dem ersten Ende der Spalte lediglich eine Stromquelle und eine Referenzpotentialquelle vorzusehen, und auch an dem zweiten Ende der Spalte lediglich eine Stromquelle und eine Referenzpotentialquelle vorzusehen.

Die Anordnung der ersten Vorladeschaltungen 115a-cs, 115a-rf und der zweiten Vorladeschaltungen 155b-cs, 155b-rf ist derart gewählt, dass in dem ersten Schaltzustand der zwei Umschalteinrichtungen 155a, 155b eine (z.B. 17a) der zwei ersten Spaltenleitungen mit der ersten Vorladeschaltung 115a-cs (Stromquelle) an dem ersten Ende der Spalte und mit der weiteren zweiten Vorladeschaltung 115b-rf (Referenzpotentialquelle) an dem zweiten Ende der Spalte gekoppelt ist. Die andere (z.B. 17b) der zwei ersten Spaltenleitungen ist in diesem Zustand mit der zweiten Vorladeschaltung 115b-cs (Stromquelle) an dem zweiten Ende der Spalte und mit der weiteren ersten Vorladeschaltung 115a-rf (Referenzpotentialquelle) an dem ersten Ende der Spalte gekoppelt. Entsprechendes gilt für die zwei zweiten Spaltenleitungen 17c, 17d in dem zweiten Schaltzustand der zwei Umschalteinrichtungen 155a, 155b.

Fig. 10A und 10B zeigen verschiedene Anordnungen von Spaltenleitungen 17a, 17b in einem Bildsensor. Die Ober- und Unterseiten der Bildsensoren sind jeweils durch gestrichelte Linien angedeutet.

Bei einem Bildsensor gemäß einer ersten Variante (Fig. 10A) weist jede Spalte ein Spaltenleitungspaar mit Spaltenleitungen 17a und 17b auf. Die Spaltenleitungen 17a, 17b sind in einer Ebene nebeneinander ohne zwischenliegende Abschirmleitung angeordnet. Optional kann jedoch eine die Spaltenleitungen 17a, 17b überdeckende Abschirmleitung 21 vorgesehen sein, welche bevorzugt mit einem Referenzpotential verbunden ist.

Eine Variante eines Bildsensors umfasst gemäß Fig. 10B (wenigstens) vier Spaltenleitungen 17a, 17b, 17c, 17d, welche in einer 2 x 2 Matrix paarweise nebeneinander und übereinander angeordnet sind (d.h. in zwei Ebenen). Die zwei Spaltenleitungen 17a, 17b, die insbesondere den zwei ersten Spaltenleitungen 17a, 17b gemäß Fig. 9 entsprechen können, sind somit diagonal benachbart zueinander angeordnet. Die Spaltenleitungen 17c, 17d, die insbesondere den zwei zweiten Spaltenleitungen 17c, 17d gemäß Fig. 9 entsprechen können, sind - komplementär hierzu - ebenfalls diagonal benachbart zueinander angeordnet. Die Spaltenleitungen 17a, 17b, 17c, 17d sind derart mit wenigstens einer (in Fig. 10B nicht dargestellten) Umschalteinrichtung gekoppelt, dass in einem ersten Schaltzustand die Spaltenleitungen 17a, 17b mit einer jeweiligen Vorladeschaltung gekoppelt sind, während die Spaltenleitungen 17c, 17d mit einer jeweiligen Spaltenausleseschaltung gekoppelt sind. In einem zweiten Schaltzustand ist die Zuordnung vertauscht, sodass die Spaltenleitungen 17a, 17b mit der jeweiligen Spaltenausleseschaltung und die Spaltenleitungen 17c, 17d mit der jeweiligen Vorladeschaltung gekoppelt sind.

Somit sind diejenigen Spaltenleitungen, auf denen während eines bestimmten Schaltzustandes ein gleichzeitiges Auslesen der Pixel erfolgt, stets in diagonaler Richtung voneinander beabstandet. Somit verringert sich aufgrund des größeren Abstandes das Übersprechen im Vergleich zu einer Anordnung, bei der die Spaltenleitungen, über die gleichzeitig ein Auslesevorgang stattfindet, unmittelbar nebeneinander oder übereinander angeordnet sind.

### Bezugszeichenliste

- 11, 11a, 11b: Pixel
- 15: Photodiode
- 17, 17a, 17b: Spaltenleitung
- 21: Abschirmleitung
- 31: Stromquelle
- 33: Trennschalter
- 39: Transfer-Gate
- 41: Ausleseknoten
- 43: Wandler-FET
- 45: Rücksetz-FET
- 47: Auswahl-FET
- 51: positive Versorgung
- 113, 113a, 113b: Spaltenausleseschaltung
- 115, 115a, 115b: Vorladeschaltung
- 127: Referenzwert-Kondensator
- 131: Verstärker
- 133: Signalwert-Kondensator
- 135: positiver Eingang
- 137: negativer Eingang
- 149D, 149E: Schalter
- 153: Steuereinrichtung
- 155: Umschalteinrichtung
- 157: Steuerleitung
- 159: Einzelschalter
- 161: Referenzpotentialquelle
- 163: Trennschalter
- 165a, 165b: Auswahlschalter

## Patentansprüche

1. Bildsensor für elektronische Kameras,
mit einer Vielzahl von in Zeilen und Spalten angeordneten lichtempfindlichen Pixeln (11) zur Erzeugung von belichtungsabhängigen Pixelsignalen, wobei einer jeweiligen Spalte mehrere Spaltenleitungen (17), wenigstens eine Vorladeschaltung (115) zum Laden oder Entladen der Spaltenleitungen (17) und wenigstens eine Spaltenausleseschaltung (113) zum Auslesen der Pixelsignale der jeweiligen Spalte zugeordnet sind,
**dadurch gekennzeichnet,**
**dass** der jeweiligen Spalte wenigstens eine Umschalteinrichtung (155) zugeordnet ist, welche angepasst ist, in einem ersten Schaltzustand eine der Spaltenleitungen (17) der jeweiligen Spalte mit der wenigstens einen Vorladeschaltung (115) und eine andere der Spaltenleitungen (17) der jeweiligen Spalte mit der wenigstens einen Spaltenausleseschaltung (113) zu koppeln.

2. Bildsensor nach Anspruch 1,
wobei die wenigstens eine Umschalteinrichtung (155) angepasst ist, in einem zweiten Schaltzustand die eine der Spaltenleitungen (17) mit der wenigstens einen Spaltenausleseschaltung (113) oder einer weiteren Spaltenausleseschaltung der jeweiligen Spalte und die andere der Spaltenleitungen (17) mit der wenigstens einen Vorladeschaltung (115) oder einer weiteren Vorladeschaltung der jeweiligen Spalte zu koppeln.

3. Bildsensor nach Anspruch 2,
wobei der Bildsensor eine Steuereinrichtung (153) aufweist, welche angepasst ist, die wenigstens eine Umschalteinrichtung (155) derart zu steuern, dass die wenigstens eine Umschalteinrichtung (155) zwischen dem ersten Schaltzustand und dem zweiten Schaltzustand alterniert.

4. Bildsensor nach Anspruch 2 oder 3,
wobei der jeweiligen Spalte wenigstens eine erste Spaltenleitung (17a) und wenigstens eine zweite Spaltenleitung (17b) zugeordnet sind, wobei ein Teil der Pixel (11a) der jeweiligen Spalte mit der ersten Spaltenleitung (17a) und ein anderer Teil der Pixel (11b) der jeweiligen Spalte mit der zweiten Spaltenleitung (17b) verbunden oder verbindbar sind;
wobei in dem ersten Schaltzustand die erste Spaltenleitung (17a) mit der wenigstens einen Vorladeschaltung (115) und die zweite Spaltenleitung (17b) mit der wenigstens einen Spaltenausleseschaltung (113) gekoppelt ist, und wobei in dem zweiten Schaltzustand die erste Spaltenleitung (17a) mit der wenigstens einen Spaltenausleseschaltung (113) und die zweite Spaltenleitung (17b) mit der wenigstens einen Vorladeschaltung (115) gekoppelt ist.

5. Bildsensor nach einem der Ansprüche 2 bis 4,
wobei der jeweiligen Spalte zwei erste Spaltenleitungen (17a, 17b) und zwei zweite Spaltenleitungen (17c, 17d) zugeordnet sind, wobei ein Teil der Pixel (11a) der jeweiligen Spalte mit einer (17a) der zwei ersten Spaltenleitungen, ein anderer Teil der Pixel (11b) der jeweiligen Spalte mit der anderen (17b) der zwei ersten Spaltenleitungen, noch ein anderer Teil der Pixel (11c) der jeweiligen Spalte mit einer (17c) der zwei zweiten Spaltenleitungen und noch ein anderer Teil der Pixel (11d) der jeweiligen Spalte mit der anderen (17d) der zwei zweiten Spaltenleitungen verbunden oder verbindbar sind; wobei in dem ersten Schaltzustand der wenigstens einen Umschalteinrichtung (155) die zwei ersten Spaltenleitungen (17a, 17b) mit der wenigstens einen Vorladeschaltung (115) und die zwei zweiten Spaltenleitungen (17c, 17d) mit der wenigstens einen Spaltenausleseschaltung (113) gekoppelt sind, und wobei in dem zweiten Schaltzustand der wenigstens einen Umschalteinrichtung (155) die zwei ersten Spaltenleitungen (17a, 17b) mit der wenigstens einen Spaltenausleseschaltung (113) und die zwei zweiten Spaltenleitungen (17c, 17d) mit der wenigstens einen Vorladeschaltung (115) gekoppelt sind.

6. Bildsensor nach Anspruch 5,
wobei die wenigstens eine Vorladeschaltung (115) zumindest eine erste Vorladeschaltung (115a-cs) und eine zweite Vorladeschaltung (115b-cs) umfasst, wobei die wenigstens eine Spaltenausleseschaltung (113) eine erste Spaltenausleseschaltung (113a) und eine zweite Spaltenausleseschaltung (113b) umfasst, und wobei die wenigstens eine Umschalteinrichtung (155) eine erste Umschalteinrichtung (155a) und eine zweite Umschalteinrichtung (155b) umfasst; wobei die erste Vorladeschaltung (115a-cs), die erste Spaltenausleseschaltung (113a) und die erste Umschalteinrichtung (155a) an einem ersten Ende der jeweiligen Spalte angeordnet sind, und wobei die zweite Vorladeschaltung (115b-cs), die zweite Spaltenausleseschaltung (113b) und die zweite Umschalteinrichtung (155b) an einem dem ersten Ende gegenüber liegenden zweiten Ende der jeweiligen Spalte angeordnet sind.

7. Bildsensor nach Anspruch 6,
wobei der Bildsensor eine Steuereinrichtung (153) aufweist, welche angepasst ist, die erste Umschalteinrichtung (155a) und die zweite Umschalteinrichtung (155b) der jeweiligen Spalte synchron zueinander steuern.

8. Bildsensor nach Anspruch 6 oder 7,
wobei in dem ersten Schaltzustand der ersten Umschalteinrichtung (155a) und der zweiten Umschalteinrichtung (155b) der jeweiligen Spalte eine der zwei ersten Spaltenleitungen (17a, 17b) mit der ersten Vorladeschaltung (115a-cs) und die andere der zwei ersten Spaltenleitungen (17a, 17b) mit der zweiten Vorladeschaltung (115b-cs) gekoppelt sind, und wobei in dem zweiten Schaltzustand der ersten Umschalteinrichtung (155a) und der zweiten Umschalteinrichtung (155b) der jeweiligen Spalte eine der zwei zweiten Spaltenleitungen (17c, 17d) mit der ersten Vorladeschaltung (115a-cs) und die andere der zwei zweiten Spaltenleitungen (17c, 17d) mit der zweiten Vorladeschaltung (115b-cs) gekoppelt sind.

9. Bildsensor nach Anspruch 8,
wobei die erste Vorladeschaltung (115a-cs) eine erste Stromquelle (31) und einen ersten Trennschalter (33) aufweist, der zwischen der ersten Umschalteinrichtung (155a) und der ersten Stromquelle (31) angeordnet ist, und wobei die zweite Vorladeschaltung (115b-cs) eine zweite Stromquelle (31) und einen zweiten Trennschalter (33) aufweist, der zwischen der zweiten Umschalteinrichtung (155b) und der zweiten Stromquelle (31) angeordnet ist;
wobei die wenigstens eine Vorladeschaltung (115) ferner eine weitere erste Vorladeschaltung (115a-rf) und eine weitere zweite Vorladeschaltung (115b-rf) umfasst, wobei die weitere erste Vorladeschaltung (115a-rf) eine erste Referenzpotentialquelle (161) und einen weiteren ersten Trennschalter (163) aufweist, der zwischen der ersten Umschalteinrichtung (155a) und der ersten Referenzpotentialquelle (161) angeordnet ist, und wobei die weitere zweite Vorladeschaltung (115b-rf) eine zweite Referenzpotentialquelle (161) und einen weiteren zweiten Trennschalter (163) aufweist, der zwischen der zweiten Umschalteinrichtung (155b) und der zweiten Referenzpotentialquelle (161) angeordnet ist; und
wobei in dem ersten Schaltzustand der ersten Umschalteinrichtung (155a) und der zweiten Umschalteinrichtung (155b) der jeweiligen Spalte die eine der zwei ersten Spaltenleitungen (17a, 17b) mit der weiteren zweiten Vorladeschaltung (15b-rf) und die andere der zwei ersten Spaltenleitungen (17a, 17b) mit der weiteren ersten Vorladeschaltung (15a-rf) gekoppelt sind, und wobei in dem zweiten Schaltzustand der ersten Umschalteinrichtung (155a) und der zweiten Umschalteinrichtung (155b) der jeweiligen Spalte die eine der zwei zweiten Spaltenleitungen (17c, 17d) mit der weiteren zweiten Vorladeschaltung (15b-rf) und die andere der zwei zweiten Spaltenleitungen (17c, 17d) mit der weiteren ersten Vorladeschaltung (115a-rf) gekoppelt sind.

10. Bildsensor nach einem der Ansprüche 6 bis 9,
wobei in dem ersten Schaltzustand der ersten Umschalteinrichtung (155a) und der zweiten Umschalteinrichtung (155a) der jeweiligen Spalte eine der zwei zweiten Spaltenleitungen (17c, 17d) mit der ersten Spaltenausleseschaltung (113a) und die andere der zwei zweiten Spaltenleitungen (17c, 17d) mit der zweiten Spaltenausleseschaltung (113b) gekoppelt sind, und wobei in dem zweiten Schaltzustand der ersten Umschalteinrichtung (155a) und der zweiten Umschalteinrichtung (155b) der jeweiligen Spalte eine der zwei ersten Spaltenleitungen (17a, 17b) mit der ersten Spaltenausleseschaltung (113a) und die andere der zwei ersten Spaltenleitungen (17a, 17b) mit der zweiten Spaltenausleseschaltung (113b) gekoppelt sind.

11. Bildsensor nach einem der Ansprüche 6 bis 9,
wobei zwischen der ersten Umschalteinrichtung (155a) und der ersten Spaltenausleseschaltung (113a) ein erster Auswahlschalter (165a) angeordnet ist, und wobei zwischen der zweiten Umschalteinrichtung (155b) und der zweiten Spaltenausleseschaltung (113b) ein zweiter Auswahlschalter (165b) angeordnet ist, wobei der erste Auswahlschalter (165a) und der zweite Auswahlschalter (165b) einen ersten Schaltzustand oder einen zweiten Schaltzustand einnehmen können;
wobei der Bildsensor eine Steuereinrichtung (153) aufweist, welche angepasst ist, die erste Umschalteinrichtung (155a) und die zweite Umschalteinrichtung (155b) der jeweiligen Spalte synchron zueinander steuern und den ersten Auswahlschalter (165a) und den zweiten Auswahlschalter (165b) synchron zueinander, jedoch unabhängig von der ersten Umschalteinrichtung (155a) und der zweiten Umschalteinrichtung (155a) zu steuern;
wobei in dem ersten Schaltzustand der ersten Umschalteinrichtung (155a) und der zweiten Umschalteinrichtung (155b) der jeweiligen Spalte eine der zwei zweiten Spaltenleitungen (17c, 17d) in Abhängigkeit von dem Schaltzustand des ersten Auswahlschalters (165a) und des zweiten Auswahlschalters (165b) mit einer der ersten Spaltenausleseschaltung (113a) und zweiten Spaltenausleseschaltung (113b) und die andere der zwei zweiten Spaltenleitungen (17c, 17d) mit der anderen der ersten Spaltenausleseschaltung (113a) und zweiten Spaltenausleseschaltung (113b) gekoppelt sind, und wobei in dem zweiten Schaltzustand der ersten Umschalteinrichtung (155a) und der zweiten Umschalteinrichtung (155b) der jeweiligen Spalte eine der zwei ersten Spaltenleitungen (17a, 17b) in Abhängigkeit von dem Schaltzustand des ersten Auswahlschalters (165a) und des zweiten Auswahlschalters (165b) mit einer der ersten Spaltenausleseschaltung (113a) und zweiten Spaltenausleseschaltung (113b) und die andere der zwei ersten Spaltenleitungen (17a, 17b) mit der anderen der ersten Spaltenausleseschaltung (113a) und zweiten Spaltenausleseschaltung (113b) gekoppelt sind.

12. Bildsensor nach Anspruch 11,
wobei die Steuereinrichtung (153) angepasst ist, den Schaltzustand des ersten Auswahlschalters (165a) und des zweiten Auswahlschalters (165b) zwischen dem Auslesen von Pixelsignalen der Pixel (11) von verschiedenen Zeilen oder zwischen dem Auslesen von Pixelsignalen der Pixel (11) von verschiedenen Bildern einer Sequenz von Bildern zu ändern.

13. Bildsensor nach einem der vorhergehenden Ansprüche,
wobei die Umschalteinrichtung (155) mehrere Schalter (159) aufweist, wobei der Bildsensor eine Steuereinrichtung (153) aufweist, welche angepasst ist, die mehreren Schalter (159) der Umschalteinrichtung (155) über eine gemeinsame Steuerleitung (157) zu steuern.

14. Bildsensor nach einem der vorhergehenden Ansprüche,
wobei die wenigstens eine Vorladeschaltung (115) eine Stromquelle (31) und einen Trennschalter (33) aufweist, der zwischen der wenigstens einen Umschalteinrichtung (155) und der Stromquelle (31) angeordnet ist.

15. Bildsensor nach Anspruch 14,
wobei die wenigstens eine Vorladeschaltung (115) ferner eine Referenzpotentialquelle (161) und einen weiteren Trennschalter (163) aufweist, der zwischen der wenigstens einen Umschalteinrichtung (155) und der Referenzpotentialquelle (161) angeordnet ist, wobei der Bildsensor vorzugsweise eine Steuereinrichtung (153) aufweist, welche angepasst ist, zum Koppeln einer jeweiligen Spaltenleitung (17) mit der wenigstens einen Vorladeschaltung (115) zunächst den Trennschalter (33) zu schließen und den weiteren Trennschalter (163) zu öffnen, um die jeweilige Spaltenleitung (17) mit der Stromquelle (31) zu koppeln, und danach den Trennschalter (33) zu öffnen und den weiteren Trennschalter (163) zu schließen, um die jeweilige Spaltenleitung (17) mit der Referenzpotentialquelle (161) zu koppeln.

16. Bildsensor nach einem der vorhergehenden Ansprüche,
wobei ein Schaltzeitintervall (t2), während dessen eine jeweilige Spaltenleitung (17) mit der wenigstens einen Spaltenausleseschaltung (113) gekoppelt ist, und ein Schaltzeitintervall (t1), während dessen eine jeweilige Spaltenleitung (17a, 17b) mit der wenigstens einen Vorladeschaltung (115) gekoppelt ist, gleich lang sind.

17. Bildsensor nach einem der vorhergehenden Ansprüche,
wobei eine der Spaltenleitungen (17a) der jeweiligen Spalte und eine andere der Spaltenleitungen (17b) der jeweiligen Spalte unmittelbar nebeneinander verlaufen, ohne dass zwischen den beiden Spaltenleitungen (17a, 17b) eine Abschirmleitung verläuft; und/oder
wobei die mehreren Spaltenleitungen (17) der jeweiligen Spalte nebeneinander verlaufen, wobei zwischen zwei Spaltenleitungen (17), die in dem ersten Schaltzustand der wenigstens einen Umschalteinrichtung (155) mit der wenigstens einen Spaltenausleseschaltung (113) gekoppelt sind, wenigstens eine Spaltenleitung (17) verläuft, die in dem ersten Schaltzustand mit der wenigstens einen Vorladeschaltung (115) gekoppelt ist;
und/oder
wobei der jeweiligen Spalte wenigstens vier Spaltenleitungen (17a, 17b, 17c, 17d) zugeordnet sind, die in einer Querrichtung betrachtet paarweise nebeneinander und übereinander verlaufen, wobei zwei (17a, 17b) der wenigstens vier Spaltenleitungen, die in dem ersten Schaltzustand der wenigstens einen Umschalteinrichtung (155) mit der wenigstens einen Spaltenausleseschaltung (113) gekoppelt sind, diagonal benachbart zueinander angeordnet sind, und wobei die anderen zwei (17c, 17d) der wenigstens vier Spaltenleitungen, die in dem ersten Schaltzustand der wenigstens einen Umschalteinrichtung (155) mit der wenigstens einen Vorladeschaltung (115) gekoppelt sind, komplementär hierzu ebenfalls diagonal benachbart zueinander angeordnet sind.

18. Bildsensor nach einem der vorhergehenden Ansprüche, wobei der Bildsensor eine Steuereinrichtung (153) aufweist, welche angepasst ist, den Bildsensor derart zu steuern, dass für einen einzigen Belichtungsvorgang des Bildsensors in einem ersten der Pixel (11) der jeweiligen Spalte mehrere Ausleseschritte (R, S) durchgeführt werden, um mehrere Pixelsignale des ersten Pixels nacheinander zu erzeugen und an eine der Spaltenleitungen (17) der jeweiligen Spalte auszugeben, dass ferner für denselben Belichtungsvorgang auch in einem zweiten der Pixel (11) der jeweiligen Spalte mehrere Ausleseschritte (R, S) durchgeführt werden, um mehrere Pixelsignale des zweiten Pixels nacheinander zu erzeugen und an dieselbe Spaltenleitung (17) auszugeben, und dass zwischen den Ausleseschritten (R, S) des ersten Pixels wenigstens ein Ausleseschritt (R, S) des zweiten Pixels durchgeführt wird.

19. Verfahren zum Auslesen eines Bildsensors für elektronische Kameras, welcher eine Vielzahl von in Zeilen und Spalten angeordneten lichtempfindlichen Pixeln (11) umfasst, in denen belichtungsabhängige Pixelsignale erzeugt werden, wobei einer jeweiligen Spalte mehrere Spaltenleitungen (17) zugeordnet sind,
**dadurch gekennzeichnet,**
**dass** innerhalb eines Schaltzeitintervalls, in dem eines der Pixelsignale über eine der Spaltenleitungen (17) der jeweiligen Spalte ausgegeben wird, eine andere der Spaltenleitungen (17) der jeweiligen Spalte mittels wenigstens einer Vorladeschaltung (115) geladen oder entladen wird.

20. Verfahren nach Anspruch 19,
wobei innerhalb eines anderen Schaltzeitintervalls, in dem ein anderes der Pixelsignale über die andere der Spaltenleitungen (17) ausgegeben wird, die eine der Spaltenleitungen (17) mittels wenigstens einer Vorladeschaltung oder der genannten wenigstens einen Vorladeschaltung (115) geladen oder entladen wird.
